# EUROPEAN PATENT APPLICATION

(11) **EP 4 845 375 A1**
(43) Date of publication of application: **25.11.2026**
(21) Application number: 26165371.1
(22) Date of filing: 17.03.2026
(51) Int. Cl.: H10W 20/46, H10W 20/00, H10W 20/41

(54) **SEMICONDUCTOR DEVICE WITH AIRGAP AND METHOD FOR MANUFACTURING THE SAME**

(30) Priority: 19.05.2025 KR 20250064319
(71) Applicant: Samsung Electronics Co., Ltd., Suwon-si, Gyeonggi-do 16677 (KR)
(72) Inventor: LEE, Eui Bok, 16677 Suwon-si, Gyeonggi-do (KR); NOH, Woo Choel, 16677 Suwon-si, Gyeonggi-do (KR)
(74) Representative: Kuhnen & Wacker Patent- und Rechtsanwaltsbüro PartG mbB

(57) **Abstract**

A semiconductor device with an air gap on top of or in an upper portion of a wiring line has improved performance and reliability. The semiconductor device includes a lower wiring line (110) and an interlayer insulating film disposed on a first surface of the lower wiring line (110). A bottom surface of the interlayer insulating film faces the lower wiring line (110). The semiconductor device includes an upper wiring structure (210ST) connected to the lower wiring line (110) and including an upper wiring line (210) and an upper wiring via (215). The upper wiring via (215) is disposed between the upper wiring line (210) and the lower wiring line (110). The semiconductor device includes a wiring upper air gap disposed on the bottom surface of the interlayer insulating film and overlapping the first surface of the lower wiring line (110). The upper wiring line (210) extends is disposed in the interlayer insulating film.

## Description

### BACKGROUND

The present disclosure relates to a semiconductor device and a method for manufacturing the same, and more particularly, to a semiconductor device including a wiring line formed in a back-end-of-line (BEOL) process and a method for manufacturing the same.

Due to development of electronic technology, down-scaling of a semiconductor device has recently progressed rapidly, thereby requiring high integration and low power consumption of a semiconductor chip. In order to cope with the demand for the high integration and low power consumption of the semiconductor chip, a feature size of the semiconductor device continues to decrease.

As contact structures of various types are used for connection between the wirings, a total length of the contact structures may increase. Accordingly, contact resistance may increase.

### SUMMARY

A purpose to be achieved by the present disclosure is to provide a semiconductor device capable of improving device performance and reliability by forming an air gap on top of or in an upper portion of a wiring line.

Another purpose to be achieved by the present disclosure is to provide a method for manufacturing a semiconductor device capable of improving device performance and reliability by forming an air gap on top of or in an upper portion of a wiring line.

The technical purposes of the present disclosure are not limited to the above-mentioned technical purposes, and other technical purposes not mentioned may be clearly understood by a person skilled in the art of the present disclosure from the following description.

According to an aspect of the present disclosure, there is provided a semiconductor device comprising, a lower wiring line including a first surface and a second surface opposite to each other in a first direction, wherein the lower wiring line extends in a second direction perpendicular to the first direction, an interlayer insulating film disposed on the first surface of the lower wiring line, wherein a bottom surface of the interlayer insulating film faces the lower wiring line, an upper wiring structure connected to the lower wiring line and including an upper wiring line and an upper wiring via, wherein the upper wiring via is disposed between the upper wiring line and the lower wiring line, and a wiring upper air gap disposed on the bottom surface of the interlayer insulating film and overlapping the first surface of the lower wiring line in the first direction, wherein the upper wiring line extends in a third direction perpendicular to the first direction, and is disposed in the interlayer insulating film.

According to another aspect of the present disclosure, there is provided a semiconductor device comprising, a lower wiring line including a first surface and a second surface opposite to each other in a first direction, wherein the lower wiring line extends in a second direction perpendicular to the first direction, an interlayer insulating film disposed on the first surface of the lower wiring line, an upper wiring structure connected to the lower wiring line and including an upper wiring line and an upper wiring via, wherein the upper wiring via is disposed between the upper wiring line and the lower wiring line and includes sidewalls opposite to each other in the second direction, and a wiring upper air gap disposed on the sidewall of the upper wiring via and extending in the second direction, wherein the upper wiring line extends in a third direction perpendicular to the first direction, and is disposed in the interlayer insulating film.

According to another aspect of the present disclosure, there is provided a semiconductor device comprising, a first lower wiring line including a first surface and a second surface opposite to each other in a first direction, wherein the first lower wiring line extends in a second direction perpendicular to the first direction, an interlayer insulating film disposed on the first surface of the first lower wiring line, wherein a bottom surface of the interlayer insulating film faces the first lower wiring line, an upper wiring structure connected to the first surface of the first lower wiring line, an etch stop film disposed between the interlayer insulating film and the first lower wiring line and extending along the bottom surface of the interlayer insulating film and the first surface of the first lower wiring line, and a wiring upper air gap disposed between the interlayer insulating film and the etch stop film, wherein the wiring upper air gap overlaps the first surface of the first lower wiring line in the first direction.

It should be noted that the effects of the present disclosure are not limited to those described above, and other effects of the present disclosure will be apparent from the following description.

### BRIEF DESCRIPTION OF DRAWINGS

The above and other aspects and features of the present disclosure will become more apparent by illustrating in detail implementations thereof with reference to the attached drawings, in which:
FIG. 1 is an example layout diagram for illustrating a semiconductor device according to some implementations.
FIGS. 2 - 3 are cross-sectional views taken along A-A and B-B of FIG. 1.
FIGS. 4 - 8 are diagrams for illustrating a semiconductor device according to some implementations, respectively.
FIG. 9 is a diagram for illustrating a semiconductor device according to some implementations.
FIGS. 10 and 11 are diagrams for illustrating a semiconductor device according to some implementations, respectively.
FIGS. 12 and 13 are diagrams for illustrating a semiconductor device according to some implementations.
FIGS. 14 and 15 are diagrams for illustrating a semiconductor device according to some implementations.
FIGS. 16 and 17 are diagrams for illustrating a semiconductor device according to some implementations.
FIG. 18 is a diagram for illustrating a semiconductor device according to some implementations.
FIGS. 19 - 21 are diagrams for illustrating a semiconductor device according to some implementations.
FIGS. 22 - 25 are diagrams for illustrating a semiconductor device according to some implementations.
FIG. 26 is a diagram for illustrating a semiconductor device according to some implementations.
FIGS. 27 and 28 are diagrams for illustrating a semiconductor device according to some implementations, respectively.
FIG. 29 is a diagram for illustrating a semiconductor device according to some implementations.
FIG. 30 is a diagram for illustrating a semiconductor device according to some implementations.
FIG. 31 is a diagram for illustrating a semiconductor device according to some implementations.
FIG. 32 is a diagram for illustrating a semiconductor device according to some implementations.
FIGS. 33 - 35 are diagrams for illustrating a semiconductor device according to some implementations.
FIGS. 36 - 42 are diagrams illustrating for illustrating intermediate structures corresponding to intermediate steps of a method for manufacturing a semiconductor device according to some implementations.
FIGS. 43 and 44 are diagrams for illustrating intermediate structures corresponding to intermediate steps of a method for manufacturing a semiconductor device according to some implementations.
FIGS. 45 and 46 are diagrams for illustrating intermediate structures corresponding to intermediate steps of a method for manufacturing a semiconductor device according to some implementations.
FIGS. 47 - 50 are diagrams illustrating for illustrating intermediate structures corresponding to intermediate steps of a method for manufacturing a semiconductor device according to some implementations.
FIGS. 51 - 53 are diagrams illustrating for illustrating intermediate structures corresponding to intermediate steps of a method for manufacturing a semiconductor device according to some implementations.
FIGS. 54 and 55 are diagrams for illustrating intermediate structures corresponding to intermediate steps of a method for manufacturing a semiconductor device according to some implementations.
FIGS. 56 - 58 are diagrams illustrating for illustrating intermediate structures corresponding to intermediate steps of a method for manufacturing a semiconductor device according to some implementations.

### DETAILED DESCRIPTIONS

The terms "first", "second", "third", and so on used herein are to describe various elements or components, but the elements or components are not limited by these terms. These terms are merely used to distinguish one element or component from another element or component. Accordingly, an element or component represented as a first element or component in the detailed description may also be represented as a second element or component in the claims.

In drawings of a semiconductor device according to some implementations, a fin-shaped transistor (FinFET) including a channel area having a shape of a fin-shaped pattern, a transistor including a nanowire or nanosheet, and a multi-bridge channel field effect transistor (MBCFET^{™}), or a vertical transistor (Vertical FET) is shown by way of example. However, implementations of the present disclosure are not limited thereto. In another example, the semiconductor device according to some implementations may include a tunneling transistor (tunneling FET) or a three-dimensional (3D) stack transistor. In still another example, the semiconductor device according to some implementations may include a planar transistor. In addition, the present disclosure may be applied to a 2D material based transistor (a 2D material based FET) and a heterostructure thereof.

Furthermore, the semiconductor device according to some implementations may include a bipolar junction transistor, a lateral double diffused MOS (LDMOS), or etc.

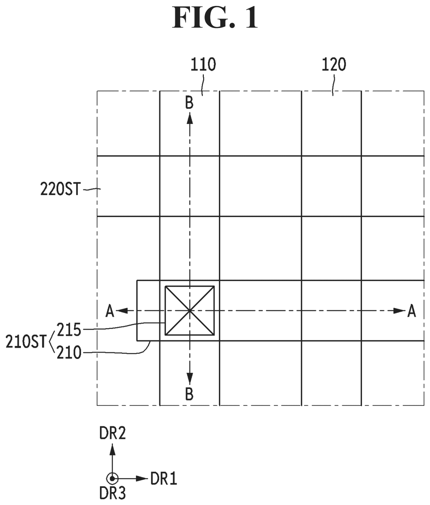

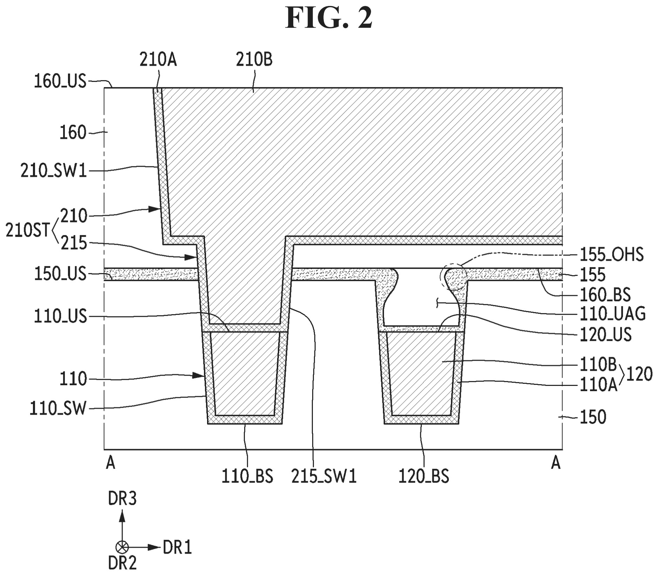

FIG. 1 is an example layout diagram for illustrating a semiconductor device according to some implementations. FIGS. 2 - 3 are cross-sectional views taken along A-A and B-B of FIG. 1.

Referring to FIGS. 1 - 3, the semiconductor device according to some implementations may include a first lower wiring line 110, a second lower wiring line 120, a first upper wiring structure 210ST, a second upper wiring structure 220ST, a first interlayer insulating film 150, a second interlayer insulating film 160, a first etch stop film 155, and a first wiring upper air gap 110_UAG.

Each of the first lower wiring line 110 and the second lower wiring line 120 may be disposed in the first interlayer insulating film 150. The first lower wiring line 110 and the second lower wiring line 120 may be disposed at a first metal level. Each of the first lower wiring line 110 and the second lower wiring line 120 may extend in an elongate manner in a second direction DR2. The first lower wiring line 110 and the second lower wiring line 120 may be spaced apart from each other in a first direction DR1.

Each of the first lower wiring line 110 and the second lower wiring line 120 may have a line shape extending in the second direction DR2. For example, the first direction DR1 may be a width direction of each of the first lower wiring line 110 and the second lower wiring line 120, and the second direction DR2 may be a length direction of each of the first lower wiring line 110 and the second lower wiring line 120.

In this regard, the first direction DR1 intersects the second direction DR2 and a third direction DR3. The second direction DR2 intersects the third direction DR3. For example, the first direction DR1, the second direction DR2, and the third direction DR3 may be orthogonal to each other.

The first interlayer insulating film 150 may be disposed on a gate electrode and a source/drain of a transistor formed in a FEOL(Front-end-of-Line) process. For example, the first interlayer insulating film 150 may be an interlayer insulating film formed in a Back-end-of-line (BEOL) process.

The first interlayer insulating film 150 may include, for example, at least one of silicon oxide, silicon nitride, silicon oxynitride, and a low dielectric constant (k) material. The low-k material may have a lower dielectric constant than that of silicon oxide. The low dielectric constant material may be, for example, silicon oxide having carbon and hydrogen at moderately high contents, for example, SiCOH. When carbon is contained in an insulating material, a dielectric constant of the insulating material may be lowered. However, to further lower the dielectric constant of the insulating material, the insulating material may contain pores, such as gas-filled or air-filled cavities.

The low dielectric constant material may include, for example, fluorinated tetraethylorthosilicate (FTEOS), hydrogen silsesquioxane (HSQ), bis-benzocyclobutene (BCB), tetramethylorthosilicate (TMOS), octamethylecyclotetrasiloxane (OMCTS), hexamethyldisiloxane (HMDS), trimethylsilyl borate (TMSB), diacetoxyditertiarybutosiloxane (DADBS), trimethylsilil phosphate (TMSP), polytetrafluoroethylene (PTFE), TOSZ (Tonen SilaZen), FSG (fluoride silicate glass), polyimide nanofoams such as polypropylene oxide, CDO (carbon doped silicon oxide), OSG (organo silicate glass), SiLK, amorphous fluorinated carbon, silica aerogels, silica xerogels, mesoporous silica, or combinations thereof.

The first lower wiring line 110 may include a first surface 110_US and a second surface 110_BS opposite to each other in the third direction DR3. The second lower wiring line 120 may include a first surface 120_US and a second surface 120_BS opposite to each other in the third direction DR3. The first surface 110_US of the first lower wiring line 110 may be an upper surface of the first lower wiring line 110, and the second surface 110_BS of the first lower wiring line 110 may be a bottom surface of the first lower wiring line 110. The first surface 120_US of the second lower wiring line 120 may be an upper surface of the second lower wiring line 120, and the second surface 120_BS of the second lower wiring line 120 may be a bottom surface of the second lower wiring line 120.

The first lower wiring line 110 may include a sidewall 110_SW connecting the first surface 110_US of the first lower wiring line 110 to the second surface 110_BS of the first lower wiring line 110. The sidewall 110_SW of the first lower wiring line 110 may extend in the second direction DR2. The second lower wiring line 120 may include a sidewall connecting the first surface 120_US of the second lower wiring line 120 to the second surface 120_BS of the second lower wiring line 120.

In the semiconductor device according to some implementations, a vertical level of each of the first surface 110_US of the first lower wiring line 110 and the first surface 120_US of the second lower wiring line 120 may be lower than a vertical level of the upper surface 150_US of the first interlayer insulating film 150. For example, a vertical length from the second surface 110_BS of the first lower wiring line 110 to the upper surface 150_US of the first interlayer insulating film 150 may be greater than a vertical length from the second surface 110_BS of the first lower wiring line 110 to the first surface 110_US of the first lower wiring line 110.

For example, a width of the first surface 110_US of the first lower wiring line 110 in the first direction DR1 may be greater than or equal to a width of the second surface 110_BS of the first lower wiring line 110 in the first direction DR1. A width of the first surface 120_US of the second lower wiring line in the first direction DR1 may be greater than or equal to a width of the second surface 120_BS of the second lower wiring line in the first direction DR1.

Each of the first lower wiring line 110 and the second lower wiring line 120 may include, for example, a lower wiring barrier film 110A and a lower wiring filling film 110B. The lower wiring filling film 110B may be disposed on the lower wiring barrier film 110A. Each of the first lower wiring line 110 and the second lower wiring line 120 may include a plurality of conductive films. Each of the first lower wiring line 110 and the second lower wiring line 120 may have a multi-conductive film structure.

For example, the lower wiring barrier film 110A may extend along a sidewall of the lower wiring filling film 110B and a bottom surface of the lower wiring filling film 110B. The lower wiring barrier film 110A may include a second surface 110_BS of the first lower wiring line 110 and a sidewall 110_SW of the first lower wiring line 110.

The lower wiring filling film 110B includes the first surface 110_US of the first lower wiring line 110. An upper surface of the lower wiring filling film 110B may be the first surface 110_US of the first lower wiring line 110. Based on the second surface 110_BS of the first lower wiring line 110, the vertical level of the upper surface of the lower wiring filling film 110B may be the vertical level of the first surface 110_US of the first lower wiring line 110. The above-described contents may be applied to the second lower wiring line 120.

In the semiconductor device according to some implementations, the lower wiring barrier film 110A included in the first lower wiring line 110 and the second lower wiring line 120 may not extend to the upper surface 150_US of the first interlayer insulating film 150.

The lower wiring barrier film 110A may include at least one of a metal, a conductive metal nitride, a conductive metal carbide, a conductive metal oxide, a conductive metal carbonitride, a conductive metal oxynitride, or a two-dimensional (2D) material. For example, the lower wiring barrier film 110A may include at least one of tantalum (Ta), tantalum nitride (TaN), titanium (Ti), titanium nitride (TiN), titanium silicon nitride (TiSiN), ruthenium (Ru), cobalt (Co), nickel (Ni), nickel boron (NiB), tungsten (W), tungsten nitride (WN), tungsten carbonitride (WCN), zirconium (Zr), zirconium nitride (ZrN), vanadium (V), vanadium nitride (VN), molybdenum (Mo), molybdenum nitride (MoN), niobium (Nb), niobium nitride (NbN), platinum (Pt), iridium (Ir), rhodium (Rh), or a two-dimensional material. However, implementations of the present disclosure are not limited thereto. The lower wiring barrier film 110A is illustrated as a single film. However, implementations of the present disclosure are not limited thereto. the lower wiring barrier film 110A may include a plurality of conductive films.

The two-dimensional material (2D material) may include a two-dimensional allotrope or a two-dimensional compound, and for example, may include at least one of graphene, boron nitride (BN), molybdenum sulfide, molybdenum selenide, tungsten sulfide, tungsten selenide, or tantalum sulfide. However, implementations of the present disclosure are not limited thereto. That is, since the above-described two-dimensional materials are only listed by way of example, the two-dimensional material that may be included in the semiconductor device of the present disclosure is not limited to the above-described materials.

The lower wiring filling film 110B may include a metal or a conductive compound including a metal. The lower wiring filling film 110B may include, for example, at least one of aluminum (Al), copper (Cu), tungsten (W), cobalt (Co), ruthenium (Ru), silver (Ag), gold (Au), manganese (Mn), molybdenum (Mo), rhodium (Rh), iridium (Ir), RuAl, NiAl, NbB₂, MoB₂, TaB₂, V₂AlC, or CrAlC. However, implementations of the present disclosure are not limited thereto. When the lower wiring filling film 110B includes copper (Cu), the lower wiring filling film 110B may include, for example, carbon (C), silver (Ag), cobalt (Co), tantalum (Ta), indium (In), tin (Sn), zinc (Zn), manganese (Mn), titanium (Ti), magnesium (Mg), chromium (Cr), germanium (Ge), strontium (Sr), platinum (Pt), magnesium (Mg), aluminum (Al), zirconium (Zr), etc.

via pattern or a plug pattern may be disposed between the first lower wiring line 110 and the conductive pattern disposed under the first lower wiring line 110. Similarly, a via pattern or a plug pattern may be disposed between the second lower wiring line 120 and the conductive pattern disposed under the second lower wiring line 120.

The second interlayer insulating film 160 may be disposed on the first lower wiring line 110, the second lower wiring line 120, and the first interlayer insulating film 150. The second interlayer insulating film 160 may be disposed on the first surface 110_US of the first lower wiring line 110, the first surface 120_US of the second lower wiring line 120, and the upper surface 150_US of the first interlayer insulating film 150.

The second interlayer insulating film 160 may include an upper surface 160_US and a bottom surface 160_BS opposite to each other in the third direction DR3. The bottom surface 160_BS of the second interlayer insulating film 160 may face the first lower wiring line 110 and the second lower wiring line 120.

The second interlayer insulating film 160 may include, for example, at least one of silicon oxide, silicon nitride, silicon oxynitride, silicon oxycarbide, or a low dielectric constant material.

The first etch stop film 155 may be disposed between the first interlayer insulating film 150 and the second interlayer insulating film 160. The first etch stop film 155 may be disposed between the upper surface 150_US of the first interlayer insulating film 150 and the bottom surface 160_BS of the second interlayer insulating film 160. The first etch stop film 155 may be disposed between the first lower wiring line 110 and the second interlayer insulating film 160, and between the second lower wiring line 120 and the second interlayer insulating film 160.

The first etch stop film 155 may extend along the upper surface 150_US of the first interlayer insulating film 150. The first etch stop film 155 may extend along the bottom surface 160_BS of the second interlayer insulating film 160. For example, the first etch stop film 155 may be in contact with the upper surface 150_US of the first interlayer insulating film 150 and the bottom surface 160_BS of the second interlayer insulating film 160.

The first etch stop film 155 may extend along the first surface 110_US of the first lower wiring line 110 and the first surface 120_US of the second lower wiring line 120. In the semiconductor device according to some implementations, the first etch stop film 155 may be in contact with the first surface 110_US of the first lower wiring line 110 and the first surface 120_US of the second lower wiring line 120. The first etch stop film 155 may include an upper surface and a bottom surface opposite to each other. The bottom surface of the first etch stop film 155 may face the upper surface 150_US of the first interlayer insulating film 150. The upper surface of the first etch stop film 155 may face the bottom surface 160_BS of the second interlayer insulating film 160.

The first etch stop film 155 may include an overhang structure 155_OHS. In terms of a cross-sectional view, the overhang structure 155_OHS of the first etch stop film 155 may be disposed at a portion where the upper surface 150_US of the first interlayer insulating film 150 and the first surface 120_US of the second lower wiring line 120 are connected to each other. In an example, in a cross-sectional view of a portion in which the first lower wiring line 110 and the first upper wiring structure 210ST are not connected to each other, the overhang structure 155_OHS of the first etch stop film 155 may be visible.

The first etch stop film 155 may include a material having an etch selectivity based on the second interlayer insulating film 160. The first etch stop film 155 may include, for example, at least one of silicon nitride, silicon oxynitride, silicon oxycarbonitride, silicon oxyboronitride, silicon carbonitride, silicon oxycarbide, aluminum oxide, aluminum nitride, aluminum oxycarbide, or aluminum oxycarbide including hydrogen.

The first upper wiring structure 210ST and the second upper wiring structure 220ST may be disposed on the first lower wiring line 110 and the second lower wiring line 120. The first upper wiring structure 210ST and the second upper wiring structure 220ST may be disposed in the second interlayer insulating film 160.

For example, the first upper wiring structure 210ST may be connected to the first lower wiring line 110. The first upper wiring structure 210ST may be connected to the first surface 110_US of the first lower wiring line 110.

For example, the second upper wiring structure 220ST may be connected to the second lower wiring line 120. In another example, the second upper wiring structure 220ST may be connected to another lower wiring line disposed in the first interlayer insulating film 150 rather than the second lower wiring line 120.

The following description is based on the first upper wiring structure 210ST. The description of the second upper wiring structure 220ST may be substantially the same as the description of the first upper wiring structure 210ST.

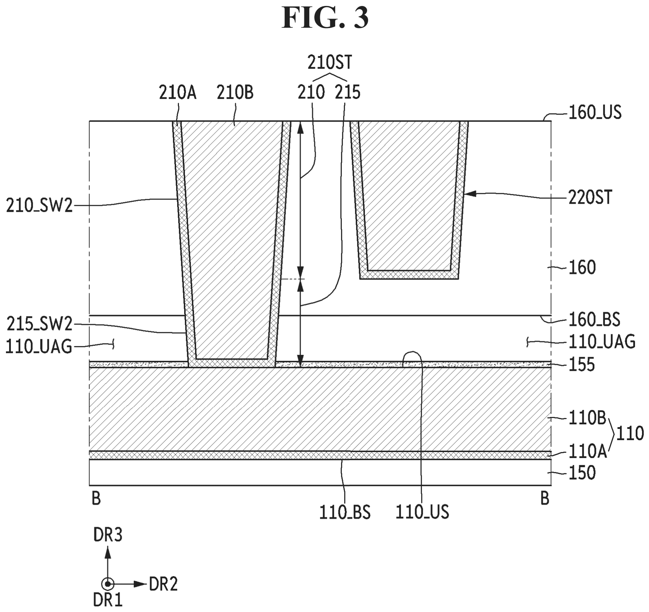

The first upper wiring structure 210ST may include a first upper wiring line 210 and a first upper wiring via 215. The first upper wiring line 210 may be disposed at a second metal level higher than the first metal level. In FIG. 3, a boundary between the first upper wiring line 210 and the first upper wiring via 215 may be defined using the second upper wiring structure 220ST adjacent thereto.

The first upper wiring line 210 may extend in the first direction DR1. In the semiconductor device according to some implementations, in a plan view, the first upper wiring line 210 disposed at the second metal level may cross the first lower wiring line 110 disposed at the first metal level in a plan view.

The first upper wiring line 210 may be disposed in the second interlayer insulating film 160. For example, the first upper wiring line 210 may be entirely disposed in the second interlayer insulating film 160.

The first upper wiring line 210 may include a first sidewall 210_SW1 extending in the second direction DR2 and a second sidewall 210_SW2 extending in the first direction DR1. The first sidewall 210_SW1 of the first upper wiring line 210 may be a short sidewall extending in the width direction of the first upper wiring line 210. The second sidewall 210_SW2 of the first upper wiring line 210 may be a long sidewall extending in the longitudinal direction of the first upper wiring line 210. The second interlayer insulating film 160 may cover an entirety of the first sidewall 210_SW1 of the first upper wiring line 210. The second interlayer insulating film 160 may cover an entirety of the second sidewall 210_SW2 of the first upper wiring line 210.

The first upper wiring via 215 may be disposed between the first upper wiring line 210 and the first lower wiring line 110. The first upper wiring via 215 may protrude from the first upper wiring line 210 toward the first lower wiring line 110. A width of the first upper wiring line 210 in the first direction DR1 is greater than a width of the first upper wiring via 215 in the first direction DR1.

The first upper wiring via 215 extends through the first etch stop film 155. The first upper wiring via 215 connects the first lower wiring line 110 and the first upper wiring line 210 to each other. The first upper wiring via 215 may be connected to the first surface 110_US of the first lower wiring line 110.

In terms of a cross-sectional view, the first upper wiring via 215 may include first sidewalls 215_SW1 opposite to each other in the first direction DR1 and second sidewalls 215_SW2 opposite to each other in the second direction DR2.

In the cross-sectional view as shown in FIG. 2, the first sidewall 215_SW1 of the first upper wiring via 215 is illustrated as being in contact with the first interlayer insulating film 150. However, implementations of the present disclosure are not limited thereto. When a portion of the first etch stop film 155 is in an area where the first upper wiring via 215 is not removed, the first etch stop film 155 may remain on the first sidewall 215_SW1 of the first upper wiring via 215.

The first upper wiring structure 210ST may include an upper wiring barrier film 210A and an upper wiring filling film 210B. The upper wiring filling film 210B may be disposed on the upper wiring barrier film 210A. Each of the first upper wiring line 210 and the first upper wiring via 215 may include the upper wiring barrier film 210A and the upper wiring filling film 210B.

The upper wiring barrier film 210A may include at least one of a metal, a conductive metal nitride, a conductive metal carbide, a conductive metal oxide, a conductive metal carbonitride, or a two-dimensional material (2D material). The upper wiring filling film 210B may include a metal or a conductive compound including a metal. Although the upper wiring barrier film 210A is illustrated as being a single film, that is only intended for convenience of illustration, and the present disclosure is not limited thereto.

Although each of the first upper wiring line 210 and the first upper wiring via 215 is illustrated as having a shape formed using a dual damascene process, this is only for convenience of explanation, and the present disclosure is not limited thereto.

The first wiring upper air gap 110_UAG may overlap the first lower wiring line 110 in the third direction DR3. The first wiring upper air gap 110_UAG may overlap the second lower wiring line 120 in the third direction DR3.

The first wiring upper air gap 110_UAG may overlap the first surface 110_US of the first lower wiring line 110 and the first surface 120_US of the second lower wiring line 120 in the third direction DR3. The first wiring upper air gap 110_UAG may overlap the second surface 110_BS of the first lower wiring line 110 and the second surface 120_BS of the second lower wiring line 120 in the third direction DR3.

In the semiconductor device according to some implementations, the first wiring upper air gap 110_UAG may be disposed on the first lower wiring line 110 and the second lower wiring line 120. The first wiring upper air gap 110_UAG may be disposed on the first surface 110_US of the first lower wiring line 110 and the first surface 120_US of the second lower wiring line 120.

The first wiring upper air gap 110_UAG may extend along the first surface 110_US of the first lower wiring line 110. The first wiring upper air gap 110_UAG may extend in the second direction DR2 in which the first lower wiring line 110 extends.

For example, the first wiring upper air gap 110_UAG may be disposed between the bottom surface 160_BS of the second interlayer insulating film 160 and the first surface 110_US of the first lower wiring line 110, and between the bottom surface 160_BS of the second interlayer insulating film 160 and the first surface 120_US of the second lower wiring line 120.

The first wiring upper air gap 110_UAG may be disposed on the sidewall of the first upper wiring via 215. The first wiring upper air gap 110_UAG may be disposed on the second sidewall 215_SW2 of the first upper wiring via 215. For example, the first wiring upper air gap 110_UAG may be in contact with the second sidewall 215_SW2 of the first upper wiring via 215.

In the semiconductor device according to some implementations, the first wiring upper air gap 110_UAG may be disposed between the first etch stop film 155 and the second interlayer insulating film 160. The first wiring upper air gap 110_UAG may extend in the second direction DR2 while being disposed between the first etch stop film 155 and the second interlayer insulating film 160.

As the down-scaling of the semiconductor device proceeds, a separation distance between the lower wiring lines 110 and 120 disposed at the first metal level and the first upper wiring line 210 disposed at the second metal level may be reduced. As the separation distance between the lower wiring lines 110 and 120 and the first upper wiring line 210 decreases, the capacitance between the lower wiring lines 110 and 120 and the first upper wiring line 210 may increase. As capacitance between the wiring lines disposed at different metal levels increases, performance and reliability of the semiconductor device may deteriorate.

In this regard, as the first wiring upper air gap 110_UAG is disposed between the lower wiring lines 110 and 120 disposed at the first metal level and the first upper wiring line 210 disposed at the second metal level, the capacitance between the lower wiring lines 110 and 120 and the first upper wiring line 210 may be reduced. As the capacitance decreases, an RC delay between adjacent wiring lines may be reduced. Accordingly, performance and reliability of the semiconductor device may be improved.

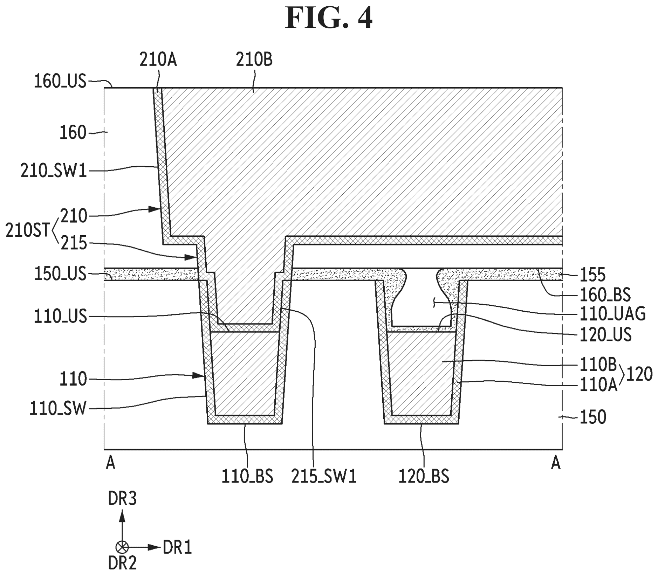

FIGS. 4 - 8 are diagrams for illustrating a semiconductor device according to some implementations, respectively. For convenience of description, differences from those described above with reference to FIGS. 1 - 3 will be mainly described.

Referring to FIG. 4, in the semiconductor device according to some implementations, a portion of the lower wiring barrier film 110A may protrude in the third direction DR3 beyond the upper surface of the lower wiring filling film 110B.

For example, the lower wiring barrier film 110A included in each of the first lower wiring line 110 and the second lower wiring line 120 may extend to the upper surface 150_US of the first interlayer insulating film 150.

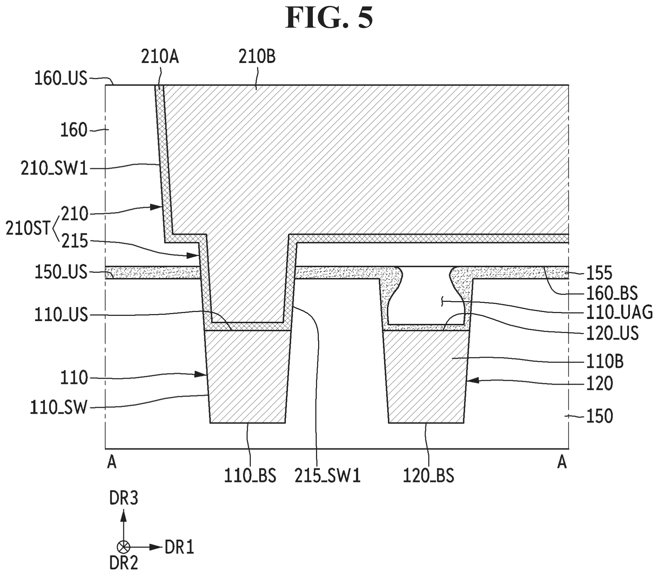

Referring to FIG. 5, in the semiconductor device according to some implementations, each of the first lower wiring line 110 and the second lower wiring line 120 may include the lower wiring filling film 110B and be free of the lower wiring barrier film 110A.

For example, each of the first lower wiring line 110 and the second lower wiring line 120 may have a single conductive film structure made of a single conductive material.

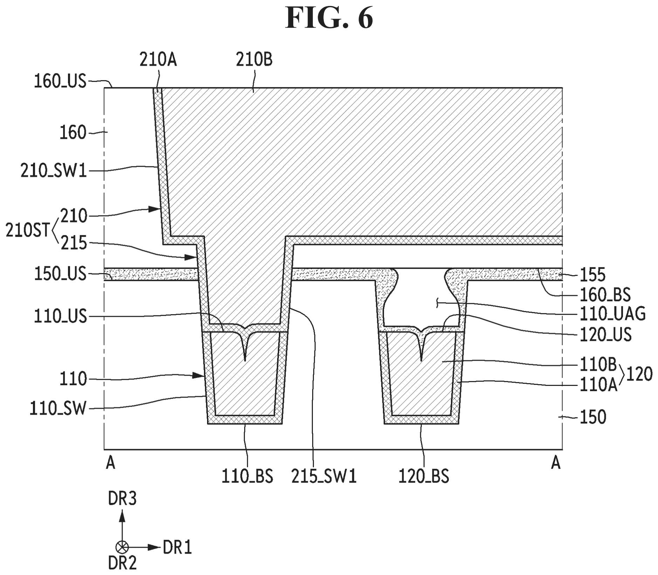

Referring to FIG. 6, in the semiconductor device according to some implementations, the first surface 110_US of the first lower wiring line 110 and the first surface 120_US of the second lower wiring line 120 may include a dent area extending in the third direction DR3.

For example, each of the first surface 110_US of the first lower wiring line 110 and the first surface 120_US of the second lower wiring line 120 may include a portion in which two convex curved surfaces are connected to each other. In terms of cross-sectional view, each of the first lower wiring line 110 and the second lower wiring line 120 may have a shape similar to that of "V".

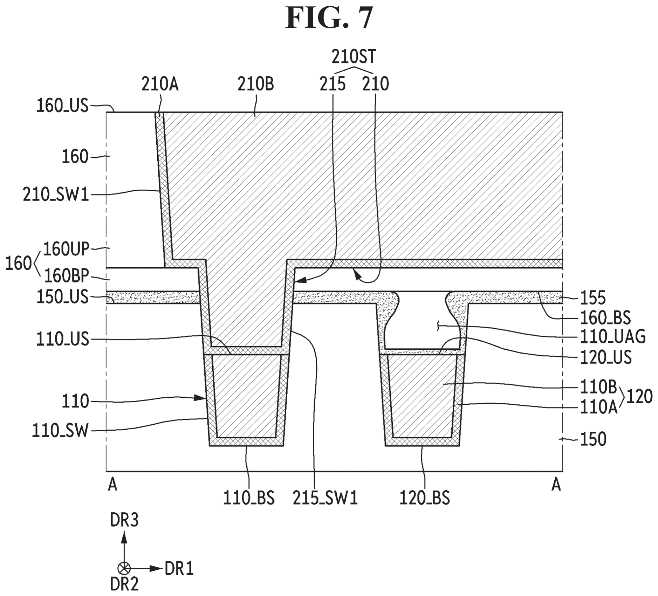

Referring to FIG. 7, in the semiconductor device according to some implementations, the second interlayer insulating film 160 may include a second lower interlayer insulating film 160BP and a second upper interlayer insulating film 160UP.

The second lower interlayer insulating film 160BP and the second upper interlayer insulating film 160UP may include different materials from each other. The second lower interlayer insulating film 160BP may include, for example, at least one of silicon oxide, silicon nitride, silicon oxynitride, silicon oxycarbonitride, silicon boron nitride, silicon oxyboron nitride, silicon carbonitride, silicon oxycarbide, aluminum oxide, aluminum nitride, aluminum oxycarbide, or aluminum oxycarbide including hydrogen. The second upper interlayer insulating film 160UP may include, for example, at least one of silicon oxide, silicon nitride, silicon oxynitride, silicon oxycarbide, or a low dielectric constant material.

An entirety of the first sidewall 210_SW1 of the first upper wiring line 210 is illustrated as being covered with the second upper interlayer insulating film 160UP. However, implementations of the present disclosure are not limited thereto.

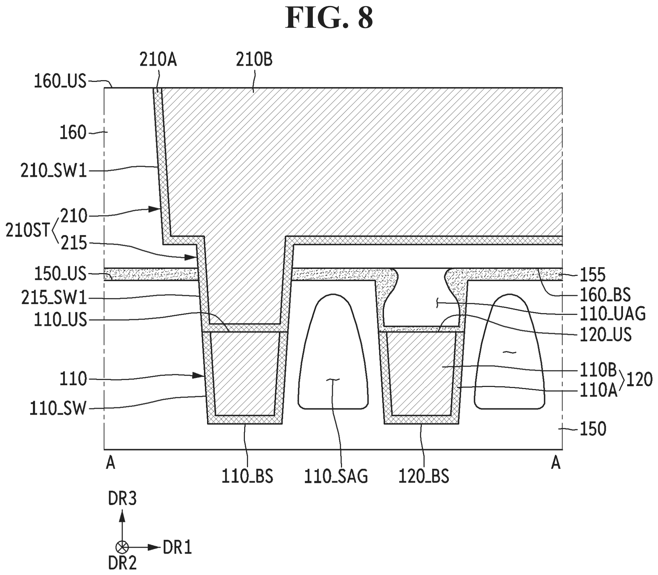

Referring to FIG. 8, the semiconductor device according to some implementations may further include a wiring sidewall air gap 110_SAG disposed in the first interlayer insulating film 150.

The wiring sidewall air gap 110_SAG may be disposed on the sidewall 110_SW of the first lower wiring line 110. Although the wiring sidewall air gap 110_SAG is illustrated as being disposed only on one side of the first lower wiring line 110, the present disclosure is not limited thereto. Depending on the separation distance between the lower wiring lines 110 and 120 disposed at the first metal level, a portion in which the wiring sidewall air gap 110_SAG is disposed and a portion in which the wiring sidewall air gap 110_SAG is not disposed may be arranged in a mixed manner.

The wiring sidewall air gap 110_SAG may extend to the first etch stop film 155. In other words, the wiring sidewall air gap 110_SAG may be in contact with the first etch stop film 155.

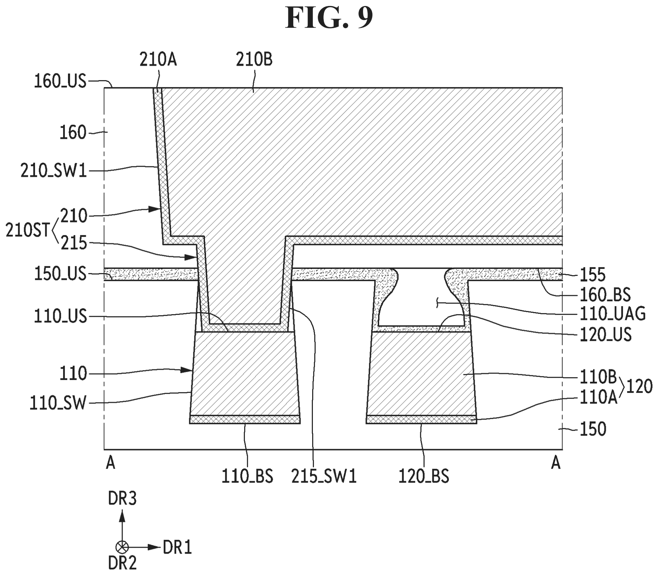

FIG. 9 is a diagram for illustrating a semiconductor device according to some implementations. For convenience of description, differences from those described above with reference to FIGS. 1 - 3 will be mainly described.

Referring to FIG. 9, in the semiconductor device according to some implementations, a width of the first surface 110_US of the first lower wiring line 110 in the first direction DR1 may be smaller than or equal to a width of the second surface 110_BS of the first lower wiring line 110 in the first direction DR1.

A width of the first surface 120_US of the second lower wiring line in the first direction DR1 may be smaller than or equal to a width of the second surface 120_BS of the second lower wiring line in the first direction DR1.

The lower wiring barrier film 110A included in the first lower wiring line 110 and the second lower wiring line 120 may extend along the bottom surface of the lower wiring filling film 110B but may not extend along the sidewall of the lower wiring filling film 110B.

For example, in a cross-sectional view, the first etch stop film 155 may remain between the first upper wiring via 215 and the first interlayer insulating film 150. In another example, in a cross-sectional view, the first wiring upper air gap 110_UAG may be disposed between the first upper wiring via 215 and the first interlayer insulating film 150.

Each of the first lower wiring line 110 and the second lower wiring line 120 may not include the lower wiring barrier film 110A.

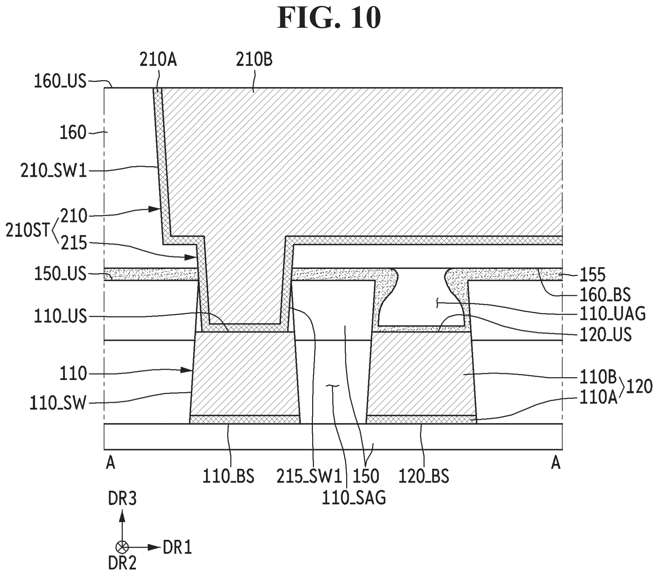

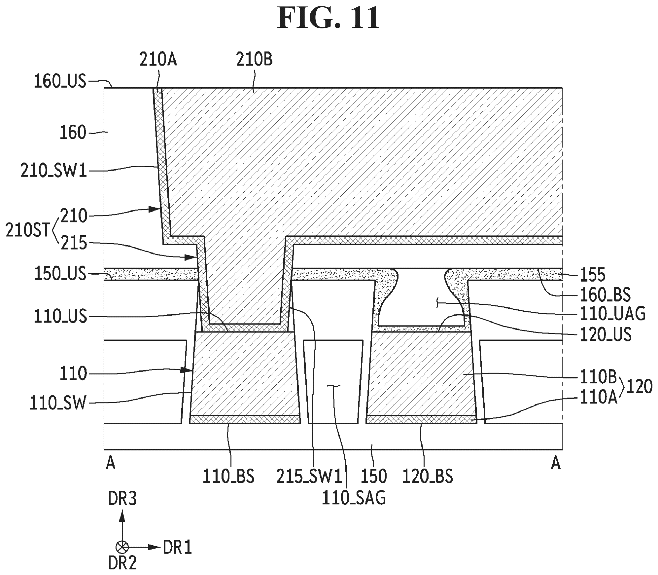

FIGS. 10 and 11 are diagrams for illustrating a semiconductor device according to some implementations, respectively. For convenience of description, differences from those described above with reference to FIG. 9 will be mainly described.

Referring to FIGS. 10 and 11, the semiconductor device according to some implementations may further include a wiring sidewall air gap 110_SAG disposed on the sidewall 110_SW of the first lower wiring line 110.

Based on the second surface 110_BS of the first lower wiring line 110, a vertical level of the uppermost surface of the wiring sidewall air gap 110_SAG is lower than a vertical level of the upper surface 150_US of the first interlayer insulating film 150.

In FIG. 10, the wiring sidewall air gap 110_SAG may be in contact with the sidewall 110_SW of the first lower wiring line 110. For example, a vertical level of the uppermost surface of the wiring sidewall air gap 110_SAG may be lower than a vertical level of the first surface 110_US of the first lower wiring line based on the second surface 110_BS of the first lower wiring line.

In FIG. 11, in a cross-sectional view, the wiring sidewall air gap 110_SAG may be surrounded with the first interlayer insulating film 150. A portion of the first interlayer insulating film 150 may be disposed between the wiring sidewall air gap 110_SAG and the first lower wiring line 110 and between the wiring sidewall air gap 110_SAG and the second lower wiring line 120. The vertical level of the uppermost surface of the wiring sidewall air gap 110_SAG is illustrated as being lower than a vertical level of the first surface 110_US of the first lower wiring line 110 based on the second surface 110_BS of the first lower wiring line 110. However, implementations of the present disclosure are not limited thereto. For example, based on the second surface 110_BS of the first lower wiring line 110, the vertical level of the uppermost surface of the wiring sidewall air gap 110_SAG may be higher than or equal to the vertical level of the first surface 110_US of the first lower wiring line 110.

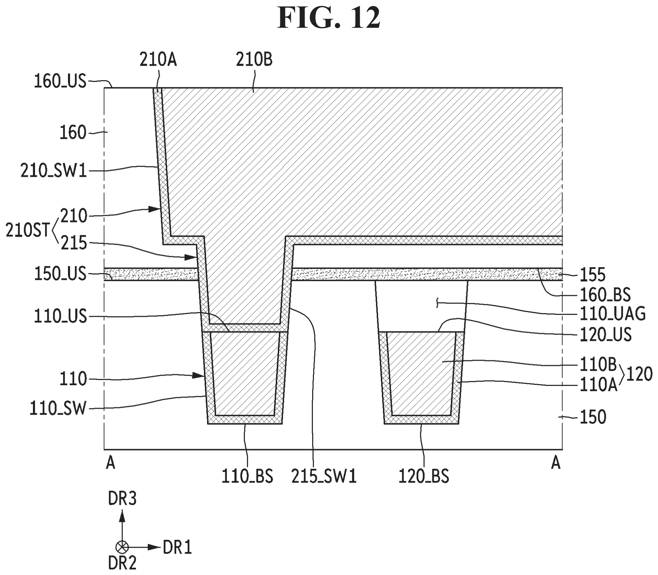

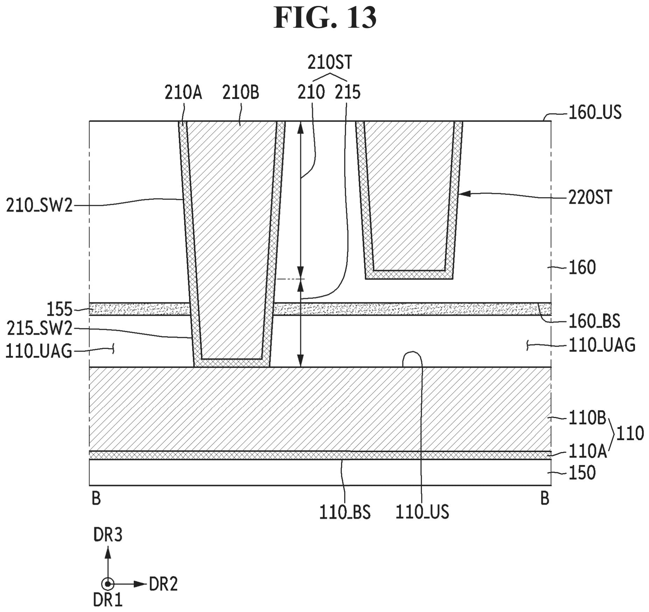

FIGS. 12 and 13 are diagrams for illustrating a semiconductor device according to some implementations. For convenience of description, differences from those described above with reference to FIGS. 1 - 3 will be mainly described.

Referring to FIGS. 12 and 13, in the semiconductor device according to some implementations, the first wiring upper air gap 110_UAG may be disposed between the first etch stop film 155 and the first lower wiring line 110 and between the first etch stop film 155 and the second lower wiring line 120.

The first etch stop film 155 may be spaced apart from the first surface 110_US of the first lower wiring line 110 and the first surface 120_US of the second lower wiring line 120 in the third direction DR3. For example, the first etch stop film 155 may not be in contact with the first surface 110_US of the first lower wiring line 110 and the first surface 120_US of the second lower wiring line 120.

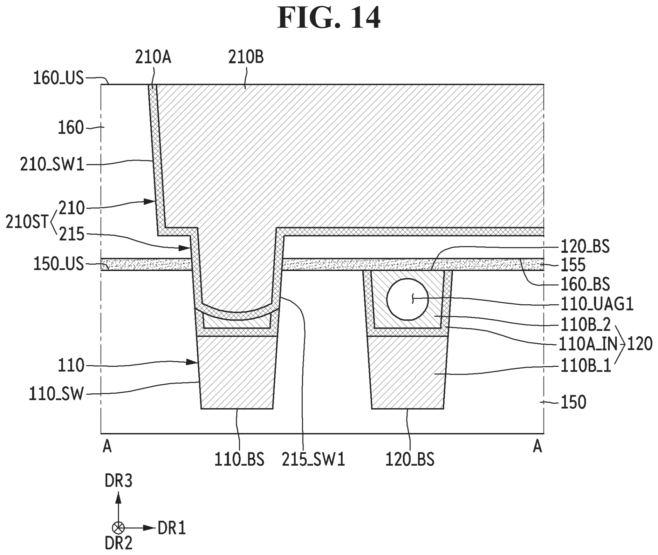

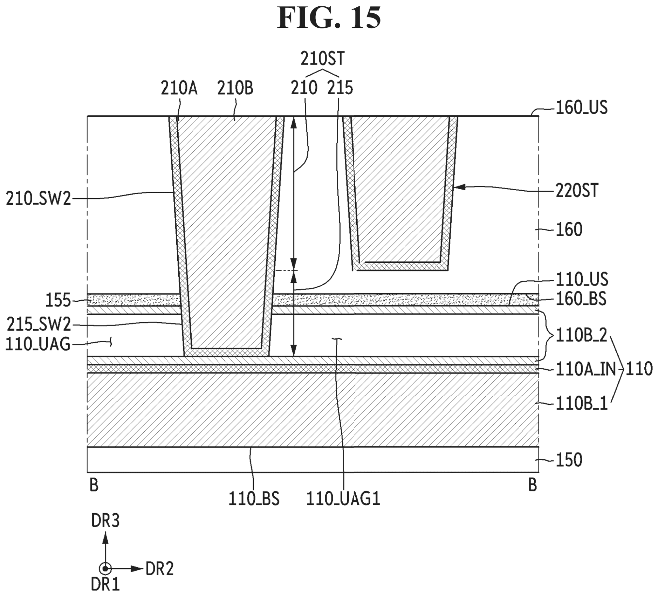

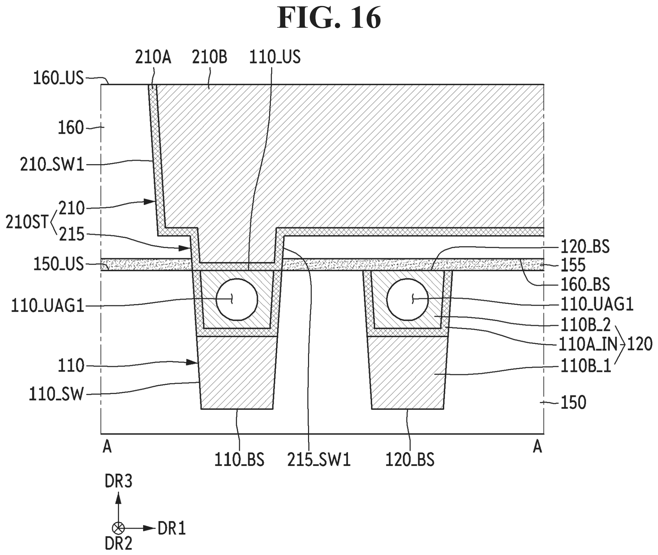

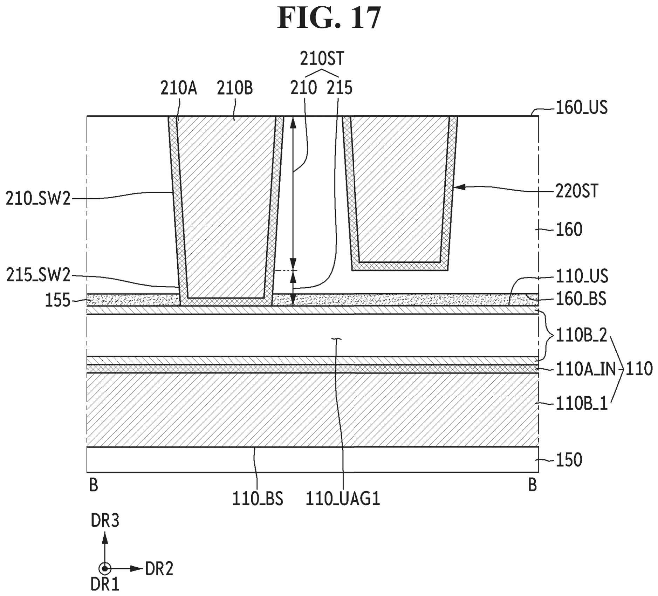

FIGS. 14 and 15 are diagrams for illustrating a semiconductor device according to some implementations. FIGS. 16 and 17 are diagrams for illustrating a semiconductor device according to some implementations. For convenience of description, differences from those described above with reference to FIGS. 1 - 3 will be mainly described.

Referring to FIGS. 14 - 17, in the semiconductor device according to some implementations, a second wiring upper air gap 110_UAG1 may be disposed in each of the first lower wiring line 110 and the second lower wiring line 120.

Each of the first lower wiring line 110 and the second lower wiring line 120 may include a first lower wiring filling film 110B_1, a lower wiring inserted barrier film 110A_IN, and a second lower wiring filling film 110B_2. The lower wiring inserted barrier film 110A_IN may be disposed between the first lower wiring filling film 110B_1 and the second lower wiring filling film 110B_2. The lower wiring inserted barrier film 110A_IN may extend along a bottom surface and sidewalls of the second lower wiring filling film 110B_2.

The second lower wiring filling film 110B_2 includes the first surface 110_US of the first lower wiring line 110. The upper surface of the second lower wiring filling film 110B_2 may be the first surface 110_US of the first lower wiring line 110. The above-described contents may be applied to the second lower wiring line 120.

Each of the first lower wiring filling film 110B_1 and the second lower wiring filling film 110B_2 may include a metal or a conductive compound including a metal. Each of the first lower wiring filling film 110B_1 and the second lower wiring filling film 110B_2 may include at least one of aluminum (Al), copper (Cu), tungsten (W), cobalt (Co), ruthenium (Ru), silver (Ag), gold (Au), manganese (Mn), molybdenum (Mo), rhodium (Rh), iridium (Ir), RuAl, NiAl, NbB₂, MoB₂, TaB₂, V₂AlC, or CrAlC. However, implementations of the present disclosure are not limited thereto.

The lower wiring inserted barrier film 110A_IN may include at least one of a metal, a conductive metal nitride, a conductive metal carbide, a conductive metal oxide, a conductive metal carbonitride, or a 2D material. The lower wiring inserted barrier film 110A_IN may include at least one of tantalum (Ta), tantalum nitride (TaN), titanium (Ti), titanium nitride (TiN), titanium silicon nitride (TiSiN), ruthenium (Ru), cobalt (Co), nickel (Ni), nickel boron (NiB), tungsten (W), tungsten nitride (WN), tungsten carbonitride (WCN), zirconium (Zr), zirconium nitride (ZrN), vanadium (V), vanadium nitride (VN), molybdenum (Mo), molybdenum nitride (MoN), niobium (Nb), niobium nitride (NbN), platinum (Pt), iridium (Ir), rhodium (Rh), or a two-dimensional material. However, implementations of the present disclosure are not limited thereto.

The second wiring upper air gap 110_UAG1 may be disposed on the bottom surface 160_BS of the second interlayer insulating film 160. The second wiring upper air gap 110_UAG1 may be disposed in, for example, the second lower wiring filling film 110B_2.

Since the second wiring upper air gap 110_UAG1 is disposed in each of the first lower wiring line 110 and the second lower wiring line 120, the second wiring upper air gap 110_UAG1 may overlap each of the first surface 110_US of the first lower wiring line 110 and the first surface 120_US of the second lower wiring line 120 in the third direction DR3. The second wiring upper air gap 110_UAG1 may overlap each of the second surface 110_BS of the first lower wiring line 110 and the second surface 120_BS of the second lower wiring line 120 in the third direction DR3.

In FIGS. 14 and 15, a portion of the first upper wiring via 215 may extend into the first lower wiring line 110. The second wiring upper air gap 110_UAG1 may be disposed on a sidewall of the first upper wiring via 215. The second wiring upper air gap 110_UAG1 may be disposed on the second sidewall 215_SW2 of the first upper wiring via 215. For example, the second wiring upper air gap 110_UAG1 may be in contact with the second sidewall 215_SW2 of the first upper wiring via 215.

In FIGS. 16 and 17, the first upper wiring via 215 may be in contact with the first surface 110_US of the first lower wiring line 110. The second wiring upper air gap 110_UAG1 may be disposed under the first upper wiring via 215. The first upper wiring via 215 may not extend into the first lower wiring line 110.

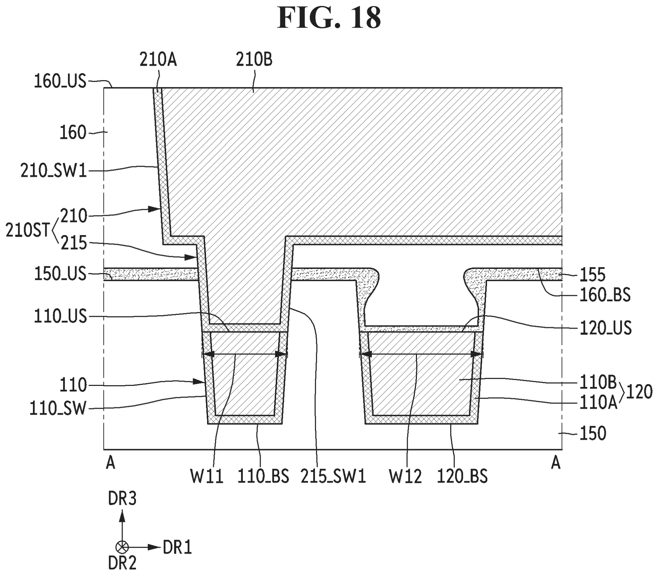

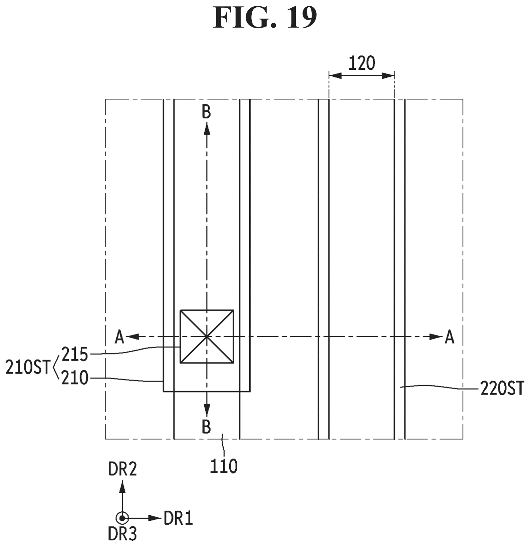

FIG. 18 is a diagram for illustrating a semiconductor device according to some implementations. FIGS. 19 - 21 are diagrams for illustrating a semiconductor device according to some implementations. For convenience of description, differences from those described above with reference to FIGS. 1 - 3 will be mainly described.

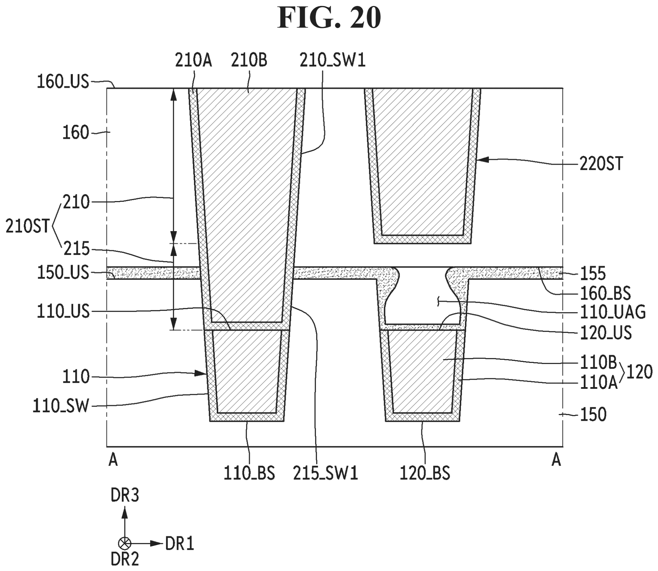

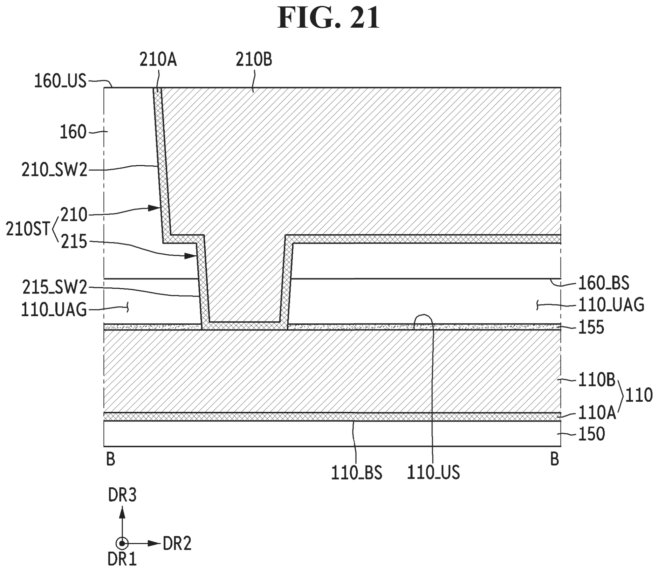

For reference, FIG. 19 is an example layout diagram for illustrating a semiconductor device according to some implementations. FIGS. 20 and 21 are cross-sectional views taken along lines A-A and B-B of FIG. 19.

Referring to FIG. 18, in the semiconductor device according to some implementations, a width W12 of the second lower wiring line 120 in the first direction DR1 may be greater than a width W11 of the first lower wiring line 110 in the first direction DR1.

The widths of the first lower wiring line 110 and the second lower wiring line 120 are compared with each other based on the first surface 110_US of the first lower wiring line 110 and the first surface 120_US of the second lower wiring line 120. However, implementations of the present disclosure are not limited thereto.

The overhang structure 155_OHS (see FIG. 2) of the first etch stop film 155 may also be formed on the second lower wiring line 120 having a width greater than that of the first lower wiring line 110. Even though the overhang structure 155_OHS of the first etch stop film 155 is formed on the second lower wiring line 120, a distance between the overhang structures 155_OHS of the first etch stop film 155 adjacent to each other in the first direction DR1 may be large. Accordingly, the second interlayer insulating film 160 may fill a space on the first surface 120_US of the second lower wiring line 120.

In other words, the first wiring upper air gap 110_UAG (see FIGS. 2 and 3) may not be disposed on the second lower wiring line 120 having a larger width than that of the first lower wiring line 110. That is, the first wiring upper air gap 110_UAG overlapping the second lower wiring line 120 in the third direction DR3 may not be disposed between the second lower wiring line 120 and the second interlayer insulating film 160.

Referring to FIGS. 19 - 21, in the semiconductor device according to some implementations, the first upper wiring line 210 may extend in the second direction DR2 which is the direction in which the first lower wiring line 110 extends.

That is, each of the first upper wiring line 210 disposed at the second metal level and the first lower wiring line 110 disposed at the first metal level may extend in the second direction DR2. In a plan view, the first lower wiring line 110 and the first upper wiring line 210 may extend in a parallel manner to each other.

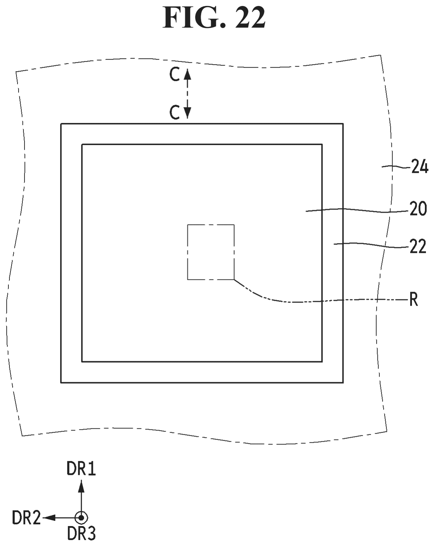

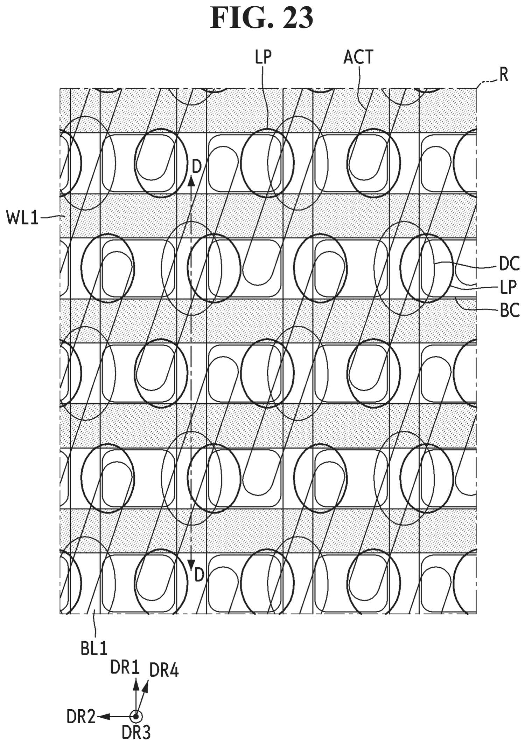

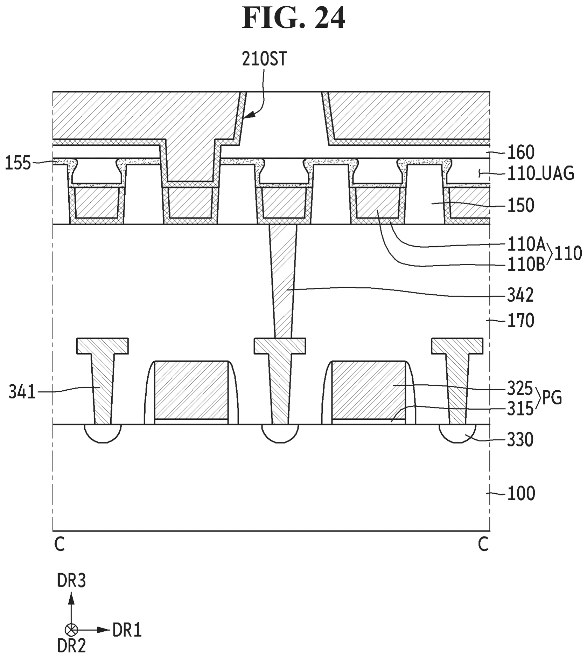

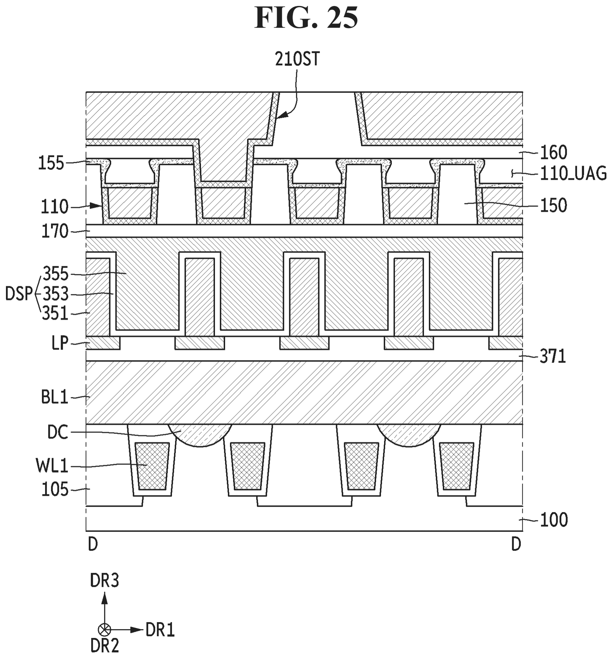

FIGS. 22 - 25 are diagrams for illustrating a semiconductor device according to some implementations. For reference, FIG. 22 is a schematic layout diagram of a semiconductor memory device according to some implementations. FIG. 23 is a layout of a R area that is a portion of the cell area of FIG. 22. FIG. 24 is a cross-sectional view taken along a line C-C of FIG. 22. FIG. 25 is a cross-sectional view taken along a line D-D of FIG. 23.

Referring to FIGS. 22 and 23, the semiconductor device according to some implementations may include a cell area 20, a cell area isolation film 22, and a peripheral area 24.

The cell area isolation film 22 may be formed along a periphery of the cell area 20. The cell area isolation film 22 may isolate the cell area 20 and the peripheral area 24 from each other. The peripheral area 24 may be defined around the cell area 20.

The cell area 20 may include a plurality of cell active areas ACT. The cell active area ACT may be defined by the cell element isolation film (105 in FIG. 25) formed in the substrate (100 in FIG. 25). In order to cope with a decrease in the design rule of the semiconductor device, the cell active area ACT may extend in the form of a bar of a diagonal line or an oblique line as shown in the drawing. For example, the cell active area ACT may extend in a fourth direction DR4.

A plurality of gate electrodes may extend in the second direction DR2 and across the cell active area ACT. The plurality of gate electrodes may extend parallel to each other. The plurality of gate electrodes may be, for example, a plurality of first word lines WL1. The first word lines WL1 may be arranged so as to be spaced from each other by an equal spacing. A width of the first word line WL1 or the spacing between the first word lines WL1 may be determined according to a design rule.

Each cell active area ACT may be divided into three portions via the two first word lines WL1 extending in the second direction DR2. The cell active area ACT may include a bit line connection area and a storage connection area. The bit line connection area may be located at a middle portion of the cell active area ACT, and the storage connection area may be located at an end of the cell active area ACT.

A plurality of first bit lines BL1 extending in the first direction DR1 perpendicular to the first word line WL1 may be disposed on the first word line WL1. The plurality of first bit lines BL1 may extend parallel to each other. The first bit lines BL1 may be arranged so as to be spaced from each other by an equal spacing. A width of the first bit line BL1 or the spacing between the first bit lines BL1 may be determined according to a design rule.

The semiconductor device according to some implementations may include various contact arrangements formed on the cell active area ACT. The various contact arrangements may include, for example, a direct contact (DC), a buried contact (BC), and a landing pad (LP).

In this regard, the direct contact DC may refer to a contact that electrically connects the cell active area ACT to the first bit line BL1. The buried contact BC may refer to a contact that connects the cell active area ACT to a lower electrode (351 of FIG. 25) of a data storage pattern. Due to the arrangement structure, a contact area between the buried contact BC and the cell active area ACT may be small. Accordingly, a conductive landing pad LP may be introduced in order to increase a contact area thereof with the lower electrode 351 (see FIG. 25) of the data storage pattern while increasing the contact area thereof with the cell active area ACT.

The landing pad LP may be disposed between the buried contact BC and the lower electrode 351 of FIG. 25 of the data storage pattern or may be disposed between the cell active area ACT and the buried contact BC. In the semiconductor memory device according to some implementations, the landing pad LP may be disposed between the buried contact BC and the lower electrode 351 of the data storage pattern. Increasing the contact area via the introduction of the landing pad LP may allow the contact resistance between the cell active area ACT and the lower electrode 351 of the data storage pattern to be reduced.

The direct contact DC may be connected to the bit line connection area of the cell active area ACT. The buried contact BC may be connected to the storage connection area of the cell active area ACT. As the buried contact BC is disposed in a position overlapping each of both opposing ends of the cell active area ACT, the landing pad LP may be disposed adjacent to each of both opposing ends of the cell active area ACT and may partially overlap with the buried contact BC. In other words, the buried contact BC may be formed to overlap the cell active area ACT and the element isolation film 105 of FIG. 25 between adjacent first word lines WL1 and between adjacent first bit lines BL1.

The first word line WL1 may be formed in a structure buried in the substrate 100. The first word line WL1 may extend across a portion of the cell active area ACT disposed between the direct contact DC and the buried contact BC. As illustrated, two first word lines WL1 may be disposed to extend across one cell active area ACT. As the cell active area ACT extends along the fourth direction DR4, the first word line WL1 may have an angle smaller than 90 degrees with respective to the extension direction of the active area ACT.

The direct contacts DC and the buried contacts BC may be arranged in a symmetrical manner. Thus, the direct contacts DC may be arranged along the first direction DR1 and the second direction DR2. The buried contacts BC may be arranged along the first direction DR1 and the second direction DR2.

In one example, unlike the direct contact DC and the buried contact BC, the landing pads LP may be arranged in a zigzag manner in the first direction DR1 in which the first bit line BL1 extends. Further, the landing pads LP may overlap with the same portion of a side face of each first bit line BL1 in the second direction DR2 in which the word line WL extends.

For example, each of the landing pads LP of a first line may overlap a left side surface of the corresponding first bit line BL1, and each of the landing pads LP of a second line may overlap a right side surface of the corresponding first bit line BL1.

Referring to FIGS. 22 - 25, the semiconductor device according to some implementations may include the first word line WL1, the first bit line BL1, a peripheral gate structure PG, a peripheral contact structure 341, the first lower wiring line 110, the first upper wiring structure 210ST, and the first wiring upper air gap 110_UAG.

The substrate 100 may be a silicon substrate, or may include a material other than silicon, for example, silicon germanium, indium antimonide, lead telluride compound, indium arsenide, indium phosphide, gallium arsenide, or gallium antimonide. However, implementations of the present disclosure are not limited thereto.

The cell element isolation film 105 may be disposed in the substrate 100. The cell element isolation film 105 may include an insulating material.

The first word line WL1 may be disposed in the substrate 100 and the cell element isolation film 105. The first word line WL1 may extend in the second direction DR2. The first word lines WL1 may be spaced apart from each other in the first direction DR1.

The first bit line BL1 may be disposed on the substrate 100 and the cell element isolation film 105. The first bit line BL1 may be disposed on the first word line WL1.

The first bit line BL1 may extend in the first direction DR1. The first bit lines BL1 may be spaced apart from each other in the second direction DR2.

The direct contact DC may be disposed between the first bit line BL1 and the substrate 100. The direct contact DC may be connected to the cell active area ACT of the substrate 100. The direct contact DC may connect the first bit line BL1 to the cell active area ACT.

The landing pad LP may be disposed on the first bit line BL1. A first cell interlayer insulating film 371 may be disposed between adjacent landing pads LP. The first cell interlayer insulating film 371 may include an insulating material.

Each of the first word line WL1, the first bit line BL1, the direct contact DC, and the landing pad LP may include at least one of a metal, a conductive metal nitride, a conductive metal carbonitride, a conductive metal carbide, a metal silicide, a doped semiconductor material, a conductive metal oxynitride, or a conductive metal oxide.

The data storage pattern DSP may be disposed on the first bit line BL1. The data storage pattern DSP may be connected to the landing pad LP. The first bit line BL1 may be disposed between the first word line WL1 and the data storage pattern DSP.

For example, the data storage patterns DSP may be capacitors. The data storage patterns DSP may include storage electrodes 351, a plate electrode 355, and a capacitor dielectric film 353 interposed between the storage electrodes 351 and the plate electrode 355. In a plan view, the storage electrode 351 may have various shapes such as a circle, an oval, a rectangle, a square, a rhombus, and a hexagon.

Each of the storage electrode 351 and the plate electrode 355 may include, for example, at least one of a conductive semiconductor material, a conductive metal nitride, a conductive metal silicon nitride, a metal carbonitride, a conductive metal silicide, a conductive metal oxide, and a metal. The capacitor dielectric film 353 may include at least one of a ferroelectric material, an antiferroelectric material, and a paraelectric material. For example, it may include one of a ferroelectric material, an anti-ferroelectric material, a paraelectric material, a combination of a ferroelectric material and an anti-ferroelectric material, a combination of a ferroelectric material and a paraelectric material, a combination of a paraelectric material and an anti-ferroelectric material, a combination of a ferroelectric material, an anti-ferroelectric material, and a paraelectric material.

Alternatively, each of the data storage patterns DSP may act as a variable resistance pattern that may be switched to two resistance states under an electrical pulse applied to a memory element. For example, the data storage pattern DSP may include a phase-change material whose crystal state changes according to the amount of current, perovskite compounds, a transition metal oxide, magnetic materials, ferromagnetic materials, or antiferromagnetic materials.

A peripheral gate structure PG may be disposed on the substrate 100. The peripheral gate structure PG may include a sensing transistor, a transmission transistor, and a driving transistor.

The peripheral gate structure PG may include a peripheral gate insulating film 315 and a peripheral gate conductive film 325. The peripheral gate insulating film 315 may include a silicon oxide film, a silicon oxynitride film, a high-k insulating film having a higher dielectric constant than that of the silicon oxide film, or a combination thereof. The high-k insulating film may include, for example, at least one of a metal oxide, a metal oxynitride, a metal silicon oxide, and a metal silicon oxynitride. However, implementations of the present disclosure are not limited thereto.

The peripheral gate conductive film 325 may include a conductive material. The peripheral gate conductive film 325 may include, for example, at least one of a doped semiconductor material, a conductive metal nitride, a conductive metal silicon nitride, a metal carbonitride, a conductive metal silicide, a conductive metal oxide, a two-dimensional material (2D material) and a metal.

Peripheral source/drain areas 330 may be respectively disposed on both opposing sides of the peripheral gate structure PG. The peripheral source/drain area 330 may be disposed in the substrate 100.

For example, the peripheral source/drain area 330 may be an impurity doped area in which an n-type or p-type impurity element is doped in the substrate 100. In another example, the peripheral source/drain area 330 may include an epitaxial semiconductor pattern. The epitaxial semiconductor pattern may be formed using an epitaxial growth method. The epitaxial semiconductor pattern may include a doped n-type or p-type impurity element. The n-type impurity element may include at least one of phosphorus (P), arsenic (As), antimony (Sb), and bismuth (Bi). The p-type impurity element may include at least one of boron (B) and gallium (Ga).

A third interlayer insulating film 170 may be disposed on the substrate 100. A portion of the third interlayer insulating film 170 may be disposed on the data storage pattern DSP. The third interlayer insulating film 170 includes an insulating material. Although the third interlayer insulating film 170 is illustrated as being a single film, it is only intended for convenience of illustration, and the present disclosure is not limited thereto.

A peripheral contact structure 341 may be disposed on the substrate 100. The peripheral contact structure 341 may be disposed in the third interlayer insulating film 170.

The peripheral contact structure 341 may be connected to the peripheral source/drain area 330. The peripheral contact structure 341 may be connected to the peripheral gate structure PG.

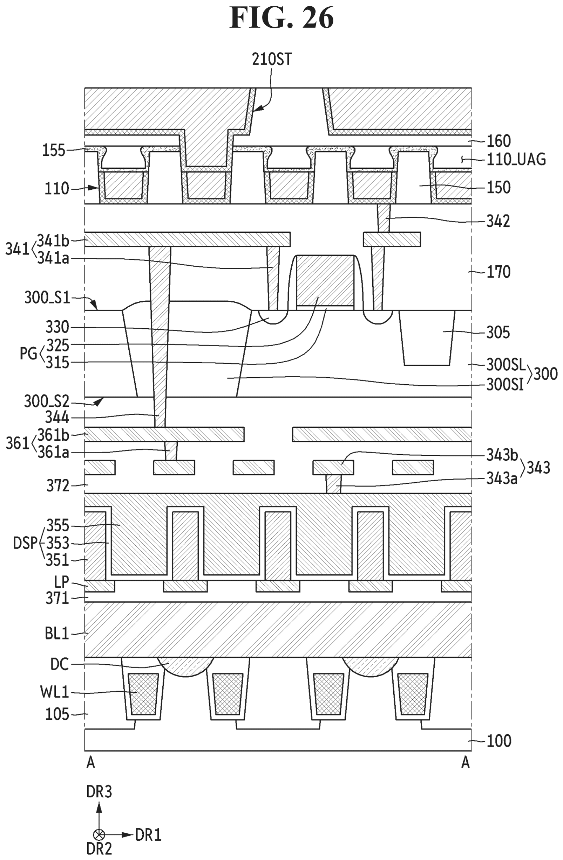

The peripheral contact structure 341 is illustrated as having a single conductive film structure. However, implementations of the present disclosure are not limited thereto. The peripheral contact structure 341 may be divided into a peripheral contact plug (341a of FIG. 26) and a peripheral wiring line (341b of FIG. 26). The peripheral contact structure 341 may include a conductive material.

The first lower wiring line 110, the first upper wiring structure 210ST, the first etch stop film 155, and the first wiring upper air gap 110_UAG may be disposed on the third interlayer insulating film 170. The detailed descriptions of the first lower wiring line 110, the first upper wiring structure 210ST, the first etch stop film 155, and the first wiring upper air gap 110_UAG may be substantially the same as those set forth above with reference to FIGS. 1 - 21.

A peripheral connection plug 342 may be disposed between the first lower wiring line 110 and the peripheral contact structure 341. The peripheral connection plug 342 may connect the first lower wiring line 110 and the peripheral contact structure 341 to each other. The peripheral connection plug 342 may include a conductive material.

An additional wiring line disposed at a metal level lower than the first metal level may be disposed between the peripheral connection plug 342 and the first lower wiring line 110. In this case, the peripheral connection plug 342 may connect the additional wiring line and the peripheral contact structure 341 to each other.

The first word line WL1 may extend in the first direction DR1, and the first bit line BL1 may extend in the second direction DR2. In this case, the shapes of the first lower conductive line 110 and the first upper conductive structure 210ST illustrated in FIG. 25 may be similar to those illustrated in FIG. 3.

FIG. 26 is a diagram for illustrating a semiconductor device according to some implementations. For convenience of description, contents duplicate the contents described using FIGS. 22 - 25 in the description of FIG. 26 will be briefly described or the descriptions thereof may be omitted.

Referring to FIG. 26, the semiconductor device according to some implementations may include the first word line WL1, the first bit line BL1, the peripheral gate structure PG, the peripheral contact structure 341, the first lower wiring line 110, the first upper wiring structure 210ST, the first wiring upper air gap 110_UAG, and a peripheral active substrate 300.

The first word line WL1 may be disposed in the substrate 100 and the cell element isolation film 105. The first bit line BL1 may be disposed on the first word line WL1. The data storage pattern DSP may be disposed on the first bit line BL1.

A second cell interlayer insulating film 372 may be disposed on the data storage pattern DSP. The second cell interlayer insulating film 372 may include an insulating material. Although the second cell interlayer insulating film 372 is illustrated as being a single film, it is only intended for convenience of illustration, and the present disclosure is not limited thereto.

A cell contact plug 343a and a cell wiring line 343b may be disposed in the second cell interlayer insulating film 372. The cell wiring line 343b may be disposed on the data storage pattern DSP, the first bit line BL1, and the first word line WL1.

The cell contact plug 343a may connect the cell wiring line 343b to the plate electrode 355 of the data storage pattern DSP. The cell contact plug 343a may connect the cell wiring line 343b and the first word line WL1 to each other, and may connect the cell wiring line 343b and the first bit line BL1 to each other.

The cell contact plug 343a and the cell wiring line 343b are illustrated as different films. However, implementations of the present disclosure are not limited thereto. A boundary between the cell contact plug 343a and the cell wiring line 343b may not be defined. Each of the cell contact plug 343a and the cell wiring line 343b includes a conductive material.

A cell connection wiring structure 361 may be disposed on the cell wiring line 343b. The cell connection wiring structure 361 may be connected to the cell wiring line 343b. The cell connection wiring structure 361 may be disposed in the second cell interlayer insulating film 372.

The cell connection wiring structure 361 may include a cell connection wiring 361b and a cell connection via 361a. Although the cell connection wiring structure 361 is illustrated as including the cell connection wiring 361b disposed at one metal level, it is only indented for convenience of illustration, and the present disclosure is not limited thereto. The cell connection wiring structure 361 may include a plurality of cell connection wirings 361b disposed at different metal levels.

Each of the cell connection wiring 361b and the cell connection via 361a may include a conductive material. Although the cell connection wiring 361b and the cell connection via 361a are illustrated as different films, the present disclosure is not limited thereto.

The peripheral active substrate 300 may be disposed on the cell connection wiring structure 361. The peripheral active substrate 300 may be spaced apart from the substrate 100 in the third direction DR3. The cell connection wiring structure 361 may be disposed between the substrate 100 and the peripheral active substrate 300.

The peripheral active substrate 300 includes a peripheral semiconductor film 300SL and a peripheral semiconductor isolation film 300SI. The peripheral active substrate 300 may include a plurality of peripheral semiconductor isolation films 300SI.

The peripheral semiconductor film 300SL includes a semiconductor material. The peripheral semiconductor film 300SL may include, for example, silicon, silicon germanium, indium antimonide, lead telluride compound, indium arsenide, indium phosphide, gallium arsenide, or gallium antimonide. However, implementations of the present disclosure are not limited thereto. In following descriptions, it is assumed that the peripheral semiconductor film 300SL is a silicon film including silicon.

The peripheral semiconductor isolation film 300SI includes an insulating material. The peripheral semiconductor isolation film 300SI is illustrated as a single film. However, implementations of the present disclosure are not limited thereto.

The peripheral active substrate 300 may include a first surface 300_S1 and a second surface 300_S2 opposite to each other in the third direction DR3. The second surface 300_S2 of the peripheral active substrate 300 may face the substrate 100 and the cell connection wiring structure 361.

Each of the first surface 300_S1 of the peripheral active substrate 300 and the second surface 300_S2 of the peripheral active substrate 300 includes the peripheral semiconductor film 300SL and the peripheral semiconductor isolation film 300SI. In other words, each of the first surface 300_S1 of the peripheral active substrate 300 and the second surface 300_S2 of the peripheral active substrate 300 may be defined by the peripheral semiconductor film 300SL and the peripheral semiconductor isolation film 300SI.

In the cross-sectional view, the second surface of the peripheral semiconductor isolation film 300SI included in the second surface 300_S2 of the peripheral active substrate 300 may be flat. The first surface of the peripheral semiconductor isolation film 300_SI included in the first surface 300_S1 of the peripheral active substrate 300 is illustrated as having a convex shape in FIGS. 26 to 29. However, implementations of the present disclosure are not limited thereto.

The peripheral element isolation film 305 may be disposed in the peripheral semiconductor film 300SL. The peripheral element isolation film 305 may be formed on the first surface of the peripheral semiconductor film 300SL included in the first surface 300_S1 of the peripheral active substrate 300. The peripheral element isolation film 305 does not extend to the second surface 300_S2 of the peripheral active substrate.

The peripheral element isolation film 305 may not be covered with the peripheral semiconductor layer 300SL. The peripheral element isolation film 305 includes an insulating material.

The peripheral gate structure PG may be disposed on the peripheral semiconductor layer 300SL. The peripheral gate structure PG may be disposed on the first surface 300_S1 of the peripheral active substrate. The peripheral source/drain area 330 may be formed in the peripheral semiconductor film 300SL.

The third interlayer insulating film 170 is disposed on the first surface 300_S1 of the peripheral active substrate. The peripheral contact plug 341a and the peripheral wiring line 341b included in the peripheral contact structure 341 may be disposed in the third interlayer insulating film 170.

The peripheral contact plug 341a may be connected to the peripheral source/drain area 330. The peripheral wiring line 341b may be disposed on the peripheral contact plug 341a and the peripheral gate structure PG. The peripheral wiring line 341b may be disposed on the first surface 300_S1 of the peripheral active substrate. The peripheral wiring line 341b is connected to the peripheral contact plug 341a.

A peripheral connection through plug 344 may be disposed between the peripheral wiring line 341b and the cell connection wiring structure 361. The peripheral connection through plug 344 may connect the peripheral wiring line 341b and the cell connection wiring structure 361 to each other. For example, the peripheral connection through plug 344 may connect the peripheral wiring line 341b and the cell connection wiring 361b to each other.

The peripheral connection through plug 344 may extend through the peripheral active substrate 300. For example, the peripheral connection through plug 344 may extend through the peripheral semiconductor isolation film 300_SI. The peripheral connection through plug 344 includes a conductive material.

The first lower wiring line 110, the first upper wiring structure 210ST, the first etch stop film 155, and the first wiring upper air gap 110_UAG may be disposed on the third interlayer insulating film 170. The detailed descriptions of the first lower wiring line 110, the first upper wiring structure 210ST, the first etch stop film 155, and the first wiring upper air gap 110_UAG may be substantially the same as those as set forth above with reference to FIGS. 1 - 21.

The peripheral connection plug 342 may be disposed between the first lower wiring line 110 and the peripheral wiring line 341b. The peripheral connection plug 342 may connect the first lower wiring line 110 and the peripheral wiring line 341b to each other.

An additional wiring line disposed at a metal level lower than a vertical level of the first metal level may be disposed between the peripheral connection plug 342 and the first lower wiring line 110. In this case, the peripheral connection plug 342 may connect the additional wiring line to the peripheral wiring line 341b.

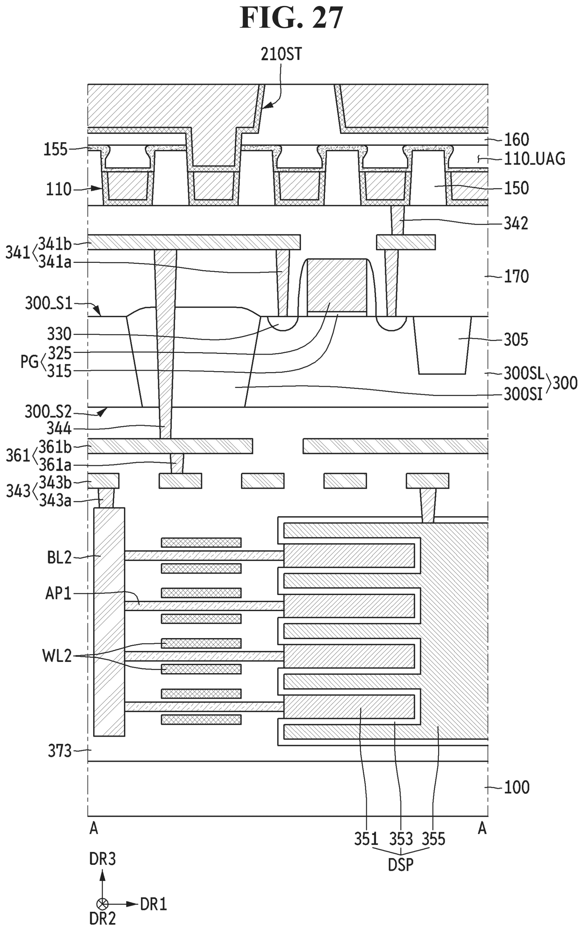

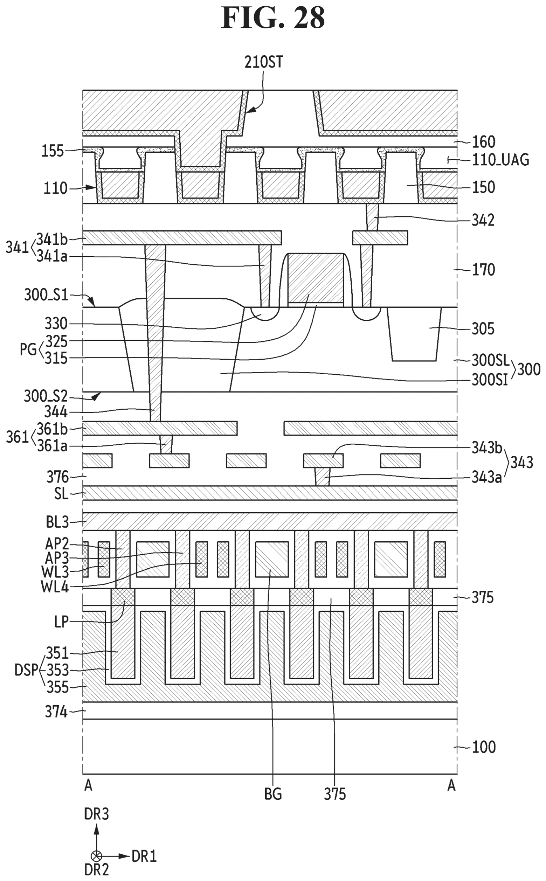

FIGS. 27 and 28 are diagrams for illustrating a semiconductor device according to some implementations, respectively. For convenience of description, differences from those described above with reference to FIG. 26 will be mainly described.

Referring to FIG. 27, the semiconductor device according to some implementations may include a first active pattern AP1, a second word line WL2, and a second bit line BL2.

A plurality of first active patterns AP1 may be disposed on the substrate 100. Each of the first active patterns AP1 may extend in the first direction DR1.

The plurality of first active patterns AP1 may be stacked in the third direction DR3. The first active patterns AP1 may be spaced apart from each other in the third direction DR3.

For example, the first active pattern AP1 may be made of a single crystal semiconductor material. For example, the first active pattern AP1 may include one of monocrystalline silicon, monocrystalline silicon-germanium, or monocrystalline germanium.

In another example, the first active pattern AP1 may include an oxide semiconductor material. The first active pattern AP1 may include, for example, a metal oxide. In one example, the first active pattern AP1 may be an amorphous metal oxide film. In another example, the first active pattern AP1 may be a polycrystalline metal oxide film. In another example, the first active pattern AP1 may be in a state in which an amorphous metal oxide film and a polycrystalline metal oxide film are combined with each other. In still another example, the first active pattern AP1 may be a CAAC (c-axis aligned crystalline) metal oxide film.

The first active pattern AP1 may include, for example, one of indium oxide, tin oxide, zinc oxide, In-Zn-based oxide (IZO), Sn-Zn-based oxide, Al-Zn-based oxide, Zn-Mg-based oxide, Sn-Mg-based oxide, In-Mg-based oxide, In-Ga-based oxide (IGO), In-Ga-Zn-based oxide (IGZO), In-Al-Zn-based oxide, In-Sn-Zn-based oxide, Sn-Ga-Zn-based oxide, Al-Ga-Zn-based oxide, Sn-Al-Zn-based oxide, In-Hf-Zn-based oxide, In-La-Zn-based oxide, In-Ce-Zn-based oxide, In-Pr-Zn-based oxide, In-Nd-Zn-based oxide, In-Sm-Zn-based oxide, In-Eu-Zn-based oxide, In-Gd-Zn-based oxide, In-Tb-Zn-based oxide, In-Dy-Zn-based oxide, In-Ho-Zn-based oxide, In-Er-Zn-based oxide, In-Tm-Zn-based oxide, In-Yb-Zn-based oxide, In-Lu-Zn-based oxide, In-Sn-Ga-Zn-based oxide, In-Hf-Ga-Zn-based oxide, In-Al-Ga-Zn-based oxide, In-Sn-Al-Zn-based oxide, In-Sn-Hf-Zn-based oxide, or In-Hf-Al-Zn-based oxide. However, the present disclosure is not limited thereto.

In this regard, the In-Ga-Zn-based oxide refers to an oxide having In, Ga, and Zn as main components, but does not refer to a ratio of contents of In, Ga, and Zn. That is, for example, when the In-Ga-Zn-based oxide is indium gallium zinc oxide (IGZO), the first active pattern AP1 may include IGZO (indium gallium zinc oxide, InₓGa_{y}Zn_{z}O). IGZO (X:Y:Z=1:1:1) including indium, gallium, and zinc at an equal content may be the In-Ga-Zn-based oxide. Ga-rich IGZO may have a higher gallium content than that in IGZO (X:Y:Z=1:1:1) and a lower indium content than that in IGZO (X:Y:Z=1:1:1). The Ga-rich IGZO may also be the In-Ga-Zn-based oxide. In addition, In-rich IGZO may have a higher indium content than that in IGZO (X:Y:Z=1:1:1) and a lower gallium content than that in IGZO (X:Y:Z=1:1:1). The In-rich IGZO may also be the In-Ga-Zn-based oxide.

The above-described description has been made based on IGZO. However, the present disclosure is not limited thereto. When the first active pattern AP1 includes a ternary or higher metal oxide, the above description may be equally applied thereto. In addition, when the first active pattern AP1 includes the In-Ga-Zn-based oxide, the first active pattern AP1 may further contain a doped metal element other than In, Ga, and Zn.

The second word line WL2 may extend in the second direction DR2. The second word lines WL2 may be spaced apart from each other in the third direction DR3.

The second word line WL2 may surround the first active pattern AP1. One second word line WL2 may surround the plurality of first active patterns AP1 disposed at the same vertical level. The second word line WL2 includes a conductive material.

The second bit line BL2 may be connected to one end of each of the first active patterns AP1. The second bit line BL2 may be connected to the plurality of first active patterns AP1 stacked in the third direction DR3.

The second bit line BL2 may extend in the third direction DR3. The adjacent second bit lines BL2 may be spaced apart from each other in the second direction DR2. The second bit line BL2 includes a conductive material.

The data storage pattern DSP may be connected to the other end of each first active pattern AP1. The other end of the first active pattern AP1 is spaced apart from one end of the first active pattern AP1 in the first direction DR1. The storage electrode 351 may be connected to each of the first active patterns AP1.

A third cell interlayer insulating film 373 may be disposed on the substrate 100. The data storage pattern DSP, the second bit line BL2, the second word line WL2, and the first active pattern AP1 may be disposed in the third cell interlayer insulating film 373.

The third cell interlayer insulating film 373 may include an insulating material. Although the third cell interlayer insulating film 373 is illustrated as being a single film, it is only intended for convenience of illustration, and the present disclosure is not limited thereto.

The cell contact plug 343a may connect the cell wiring line 343b and the second bit line BL2 to each other. The cell contact plug 343a may connect the cell wiring line 343b to the plate electrode 355 of the data storage pattern DSP to each other. The cell contact plug 343a may connect the cell wiring line 343b and the second word line WL2 to each other.

The cell contact plug 343a, the cell wiring line 343b, and the cell connection wiring structure 361 may be disposed in the third cell interlayer insulating film 373.

Referring to FIG. 28, the semiconductor device according to some implementations may include a second active pattern AP2, a third active pattern AP3, a third word line WL3, a fourth word line WL4, and a third bit line BL3.

The data storage pattern DSP may be disposed on the substrate 100. The data storage patterns DSP may be arranged in a matrix form along the first direction DR1 and the second direction DR2.

The landing pads LP may be disposed on the storage electrode 351. The landing pads LP may be connected to the second active pattern AP2 and the third active pattern AP3, respectively. Each of the landing pads LP may have various shapes such as a circle, an oval, a rectangle, a square, a rhombus, a hexagon, and the like, in a plan view.

The second active patterns AP2 and the third active patterns AP3 may be disposed on the data storage pattern DSP. The data storage patterns DSP may be disposed between the second active pattern AP2 and the substrate 100. The data storage patterns DSP may be disposed between the third active pattern AP3 and the substrate 100. The second active patterns AP2 and the third active patterns AP3 may be alternately arranged with each other along the first direction DR1. The second and third active patterns AP2 and AP3 may be two-dimensionally arranged along the first direction DR1 and the second direction DR2.

For example, each of the second active pattern AP2 and the third active pattern AP3 may be made of a single crystal semiconductor material. For example, each of the second active pattern AP2 and the third active pattern AP3 may be made of single crystalline silicon.

In another example, each of the second active pattern AP2 and the third active pattern AP3 may include an oxide semiconductor material. The second active pattern AP2 and the third active pattern AP3 may be connected to each other.

A back gate electrode BG may be disposed on the data storage pattern DSP. The back gate electrode BG may be disposed on the landing pad LP. The data storage pattern DSP may be disposed between the back gate electrode BG and the substrate 100.

The back gate electrode BG may extend in the second direction DR2. The back gate electrodes BG may be spaced apart from each other in the first direction DR1. The back gate electrodes BG may be spaced apart from each other by a predetermined spacing.

Each back gate electrode BG may be disposed between the second active pattern AP2 and the third active pattern AP3 adjacent to each other in the first direction DR1. In other words, the second active pattern AP2 may be disposed on one side of each back gate electrode BG, and the third active pattern AP3 may be disposed on the other side of each back gate electrode BG.

The second active pattern AP2 may be disposed between the third word line WL3 and the back gate electrode BG. The third active pattern AP3 may be disposed between the fourth word line WL4 and the back gate electrode BG. A pair of the third word line WL3 and the fourth word line WL4 may be disposed between the back gate electrodes BG adjacent to each other in the first direction DR1.

The back gate electrode BG may include a conductive material, and may include, for example, at least one of doped polysilicon, conductive metal nitride, conductive metal silicon nitride, metal carbonitride, conductive metal silicide, conductive metal oxide, a two-dimensional material, and a metal.

A back gate insulating film may be disposed between the back gate electrode BG and the second active pattern AP2, and between the back gate electrode BG and the third active pattern AP3.

The third word line WL3 and the fourth word line WL4 may be disposed on the data storage pattern DSP. The third word line WL3 and the fourth word line WL4 may be disposed on the landing pads LP. The data storage patterns DSP may be disposed between the third word line WL3 and the substrate 100. The data storage patterns DSP may be disposed between the fourth word line WL4 and the substrate 100.

Each of the third word line WL3 and the fourth word line WL4 may extend in the second direction DR2. The third word lines WL3 and the fourth word lines WL4 may be alternately arranged with each other in the first direction DR1 in the plan view.

The third word line WL3 and the fourth word line WL4 may be spaced apart from the third bit line BL3 and the landing pad LP in the third direction DR3. The third word line WL3 and the fourth word line WL4 may be located between the third bit line BL3 and the landing pad LP. Each of the third word line WL3 and the fourth word line WL4 may include a conductive material.

A gate insulating film may be disposed between the third word line WL3 and the second active pattern AP2, and between the fourth word line WL4 and the third active pattern AP3.

The third bit line BL3 may be disposed on the second active pattern AP2 and the third active pattern AP3. The third bit line BL3 may be connected to the second active pattern AP2 and the third active pattern AP3.

The third bit line BL3 may be disposed on the back gate electrode BG, the third word line WL3, and the fourth word line WL4. The third bit line BL3 may extend in the first direction DR1 and across the back gate electrode BG. The third bit line BL3 includes a conductive material.

A shielding conductive pattern SL may be disposed on the third bit line BL3. The third bit line BL3 may be disposed between the shielding conductive pattern SL and the third word line WL3. The third bit line BL3 may be disposed between the shielding conductive pattern SL and the fourth word line WL4. The shielding conductive pattern SL may be disposed between the third bit lines BL3 adjacent to each other in the second direction DR2.

The shielding conductive pattern SL may include a conductive material, and may include, for example, at least one of conductive metal nitride, conductive metal silicon nitride, metal carbonitride, conductive metal silicide, conductive metal oxide, a two-dimensional material, or a metal.

Although the data storage pattern DSP is illustrated as being disposed between the substrate 100 and the third bit line BL3, the present disclosure is not limited thereto. For example, the data storage pattern DSP may be disposed between the peripheral active substrate 300 and the third bit line BL3. In this case, the third bit line BL3 may be disposed between the substrate 100 and the word lines WL3 and WL4.

A fourth cell interlayer insulating film 374 may be disposed between the data storage pattern DSP and the substrate 100. The landing pad LP may be disposed in a fifth cell interlayer insulating film 375. The third and fourth word lines WL3 and WL4, the third bit line BL3, and the shielding conductive pattern SL may be disposed in a sixth cell interlayer insulating film 376.

Each of the fourth cell interlayer insulating film 374, the fifth cell interlayer insulating film 375, and the sixth cell interlayer insulating film 376 may include an insulating material. Although each of the fourth cell interlayer insulating film 374, the fifth cell interlayer insulating film 375, and the sixth cell interlayer insulating film 376 is illustrated as a single film, it is only intended for convenience of illustration, and the present disclosure is not limited thereto.

The cell contact plug 343a may connect the cell wiring line 343b and the shielding conductive pattern SL to each other. The cell contact plug 343a may connect the cell wiring line 343b and the third bit line BL3 to each other. The cell contact plug 343a may connect the cell wiring line 343b to the plate electrode 355 of the data storage pattern DSP. The cell contact plug 343a may connect the cell wiring line 343b to the third and fourth word lines WL3 and WL4.

The cell contact plug 343a, the cell wiring line 343b, and the cell connection wiring structure 361 may be disposed in the sixth cell interlayer insulating film 376.

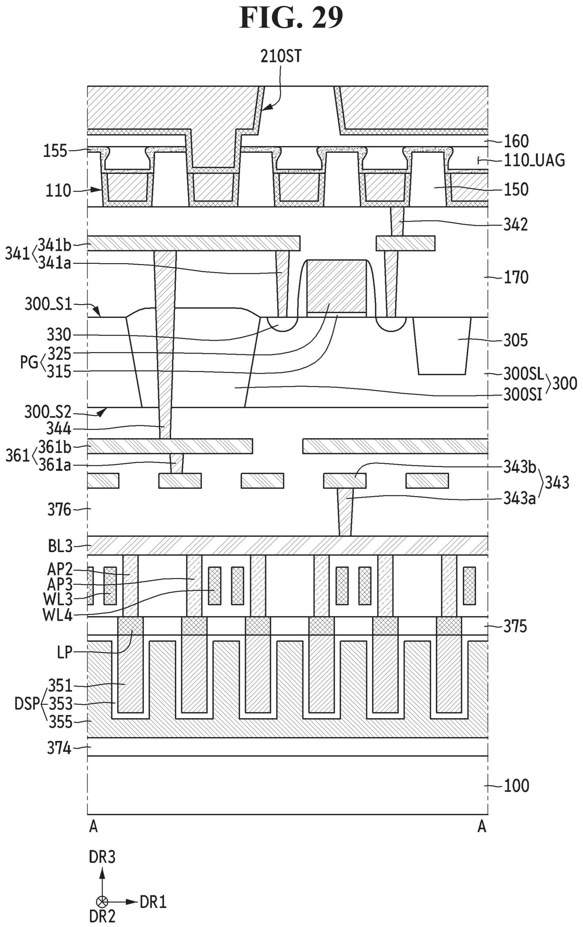

FIG. 29 is a diagram for illustrating a semiconductor device according to some implementations. For convenience of description, differences from those described above with reference to FIG. 28 will be mainly described.

Referring to FIG. 29, the semiconductor device according to some implementations may not include the back gate electrode BG (see FIG. 28).

The back gate electrode BG may not be disposed between the second active pattern AP2 and the third active pattern AP3 which are adjacent to each other in the first direction DR1.

In addition, the shielding conductive pattern SL (see FIG. 28) may not be disposed between the third bit lines BL3 adjacent to each other in the second direction DR2.

The semiconductor device according to some example implementations may include one of the back gate electrode BG and the shielding conductive pattern SL, and may not include the other thereof.

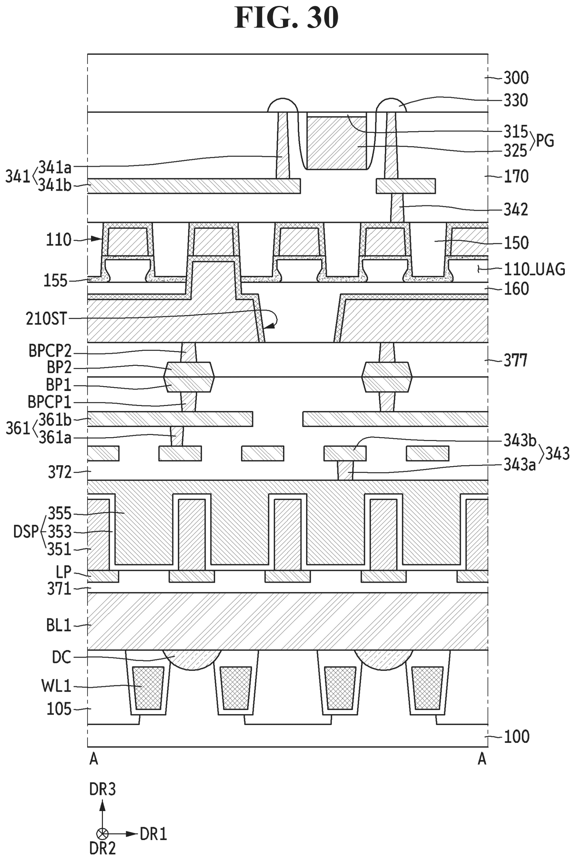

FIG. 30 is a diagram for illustrating a semiconductor device according to some implementations. For convenience of description, differences from those described above with reference to FIG. 26 will be mainly described.

Referring to FIG. 30, the semiconductor device according to some implementations may further include a first bonding pad BP1 and a second bonding pad BP2.

The first bonding pad BP1 may be disposed on the cell connection wiring structure 361. The first bonding pad BP1 may be connected to the cell connection wiring structure 361.

A first bonding pad plug BPCP1 may be disposed between the first bonding pad BP1 and the cell connection wiring structure 361. The first bonding pad plug BPCP1 may connect the first bonding pad BP1 to the cell connection wiring/line 361b.

The second bonding pad BP2 may be disposed below the second upper wiring structure 210ST. The second bonding pad BP2 may be connected to the second upper wiring structure 210ST. An additional wiring line may be disposed between the second bonding pad BP2 and the second upper wiring structure 210ST.

A second bonding pad plug BPCP2 may be disposed between the second bonding pad BP2 and the second upper wiring structure 210ST. The second bonding pad plug BPCP2 may connect the second bonding pad BP2 to the second upper wiring structure 210ST.

The second bonding pad BP2 may be connected to the first bonding pad BP1. For example, the second bonding pad BP2 may contact the first bonding pad BP1. Since the second bonding pad BP2 is electrically connected to the first bonding pad BP1, the second bonding pad BP2 may be connected to the cell connection wiring structure 361.

Each of the first bonding pad plug BPCP1 and the second bonding pad plug BPCP2 may include a conductive material including a metal. Each of the first bonding pad BP1 and the second bonding pad BP2 may include a conductive material including a metal. Although each of the first bonding pad BP1 and the second bonding pad BP2 are illustrated as being embodied as a single film, it is intended only for convenience of illustration, and the present disclosure is not limited thereto.

The first bonding pad plug BPCP1 and the first bonding pad BP1 may be disposed in the second cell interlayer insulating film 372. The second bonding pad plug BPCP2 and the second bonding pad BP2 may be disposed in a seventh cell interlayer insulating film 377. The seventh cell interlayer insulating film 377 includes an insulating material.

A bonding insulating film may be further disposed between the second cell interlayer insulating film 372 and the seventh cell interlayer insulating film 377. For example, the bonding insulating film may include SiCN. However, implementations of the present disclosure are not limited thereto.

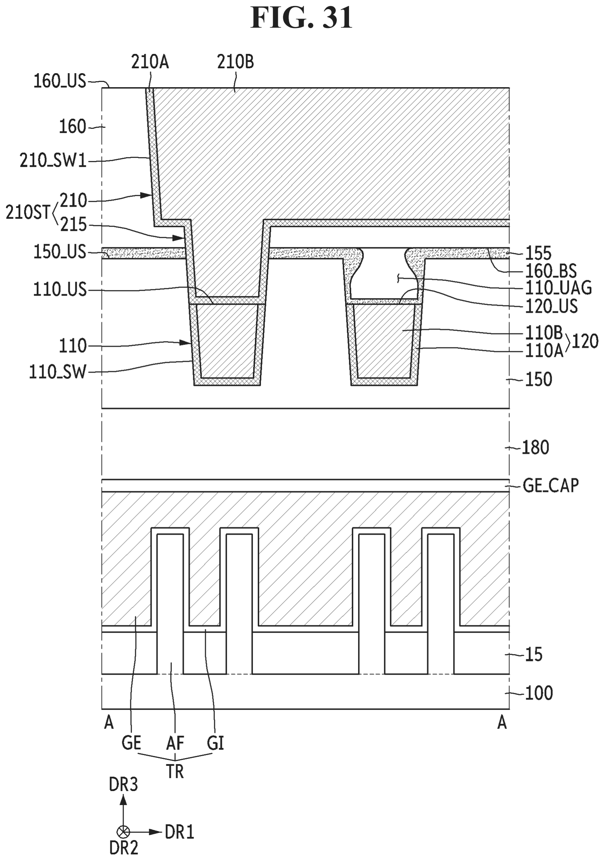

FIG. 31 is a diagram for illustrating a semiconductor device according to some implementations. For convenience of description, differences from those described above with reference to FIGS. 1 - 3 will be mainly described.

For reference, FIG. 31 illustrates an example structure as being cut along a first gate electrode GE.

In FIG. 31, a fin-shaped pattern AF extends in the second direction DR2, and the first gate electrode GE extends in the first direction DR1. However, the disclosure is not limited thereto.

Referring to FIG. 31, the semiconductor device according to some implementations may include a transistor TR disposed between the substrate 100 and the first lower wiring line 110.

The transistor TR may include the fin-shaped pattern AF, the first gate electrode GE on the fin-shaped pattern AF, and a first gate insulating film GI between the fin-shaped pattern AF and the first gate electrode GE.

The transistor TR may include source/drain patterns respectively disposed on both opposing sides of the first gate electrode GE.

The fin-shaped pattern AF may protrude from the substrate 100. The fin-shaped pattern AF may extend in an elongate manner in the second direction DR2. The fin-shaped pattern AF may be a portion of the substrate 100 or may include an epitaxial layer grown from the substrate 100. The fin-shaped pattern AF may include, for example, silicon or germanium, which is an elemental semiconductor material. In addition, the fin-shaped pattern AF may include a compound semiconductor, for example, a group IV-IV compound semiconductor or a group III-V compound semiconductor.

The group IV-IV compound semiconductor may include, for example, a binary compound including two of carbon (C), silicon (Si), germanium (Ge), and tin (Sn), a ternary compound including three thereof, or a compound obtained by doping a group IV element thereto. The group III-V compound semiconductor may include, for example, a binary compound obtained by combining one of aluminum (Al), gallium (Ga), and indium (In) as a group III element and one of phosphorus (P), arsenic (As), and antimony (Sb) as a group V element with each other, a ternary compound obtained by combining two of aluminum (Al), gallium (Ga), and indium (In) as a group III element and one of phosphorus (P), arsenic (As), and antimony (Sb) as a group V with each other, or a quaternary compound obtained by combining three of aluminum (Al), gallium (Ga), and indium (In) as a group III element and one of phosphorus (P), arsenic (As), and antimony (Sb) as a group V with each other.

The field insulating film 15 may be disposed on the substrate 100. The field insulating film 15 may be disposed on a portion of a sidewall of the fin-shaped pattern AF. The fin-shaped pattern AF may protrude upwardly beyond an upper face of the field insulating film 15. The field insulating film 15 may include, for example, silicon oxide, silicon nitride, silicon oxynitride, or a combination thereof.

The first gate electrode GE may be disposed on the fin-shaped pattern AF. The first gate electrode GE may extend in the first direction DR1. The first gate electrode GE may intersect the fin-shaped pattern AF.

The first gate electrode GE may include, for example, at least one of metal, conductive metal nitride, conductive metal carbonitride, conductive metal carbide, metal silicide, doped semiconductor material, conductive metal oxynitride, or conductive metal oxide.

The first gate insulating film GI may be disposed between the first gate electrode GE and the fin-shaped pattern AF and between the first gate electrode GE and the field insulating film 15. The first gate insulating film GI may include, for example, silicon oxide, silicon oxynitride, silicon nitride, or a high dielectric constant material having a higher dielectric constant than that of silicon oxide. The high dielectric constant material may include, for example, at least one of boron nitride, metal oxide, or metal silicon oxide. However, implementations of the present disclosure are not limited thereto.

The semiconductor device according to some implementations may include an NC (negative capacitance) FET using a negative capacitor. For example, the first gate insulating film GI may include a ferroelectric material film having ferroelectric characteristics and a paraelectric material film having paraelectric characteristics.

The ferroelectric material film may have negative capacitance, and the paraelectric material film may have positive capacitance. For example, when two or more capacitors may be connected in series to each other, and capacitance of each of the capacitors has a positive value, a total capacitance is smaller than capacitance of each individual capacitor. On the contrary, when at least one of capacitances of two or more capacitors connected in series to each other has a negative value, a total capacitance may have a positive value and be greater than an absolute value of each individual capacitance.

When the ferroelectric material film with negative capacitance and the paraelectric material film with positive capacitance are connected in series to each other, a total capacitance value of the ferroelectric material film and the paraelectric material film connected in series to each other may be increased. Using the increase in the total capacitance value, a transistor including the ferroelectric material film may have a subthreshold swing (SS) lower than about 60 mV/decade at room temperature.

The ferroelectric material film may have ferroelectric properties. The ferroelectric material film may include, for example, at least one of hafnium oxide, hafnium zirconium oxide, barium strontium titanium oxide, barium titanium oxide, or lead zirconium titanium oxide. In this connection, in one example, hafnium zirconium oxide may refer to a material obtain by doping hafnium oxide with zirconium (Zr). In another example, hafnium zirconium oxide may refer to a compound of hafnium (Hf), zirconium (Zr), and oxygen (O).

The ferroelectric material film may further contain doped dopants. For example, the dopant may include at least one of aluminum (Al), titanium (Ti), niobium (Nb), lanthanum (La), yttrium (Y), magnesium (Mg), silicon (Si), calcium (Ca), cerium (Ce), dysprosium (Dy), erbium (Er), gadolinium (Gd), germanium (Ge), scandium (Sc), strontium (Sr) or tin (Sn). A type of the dopant contained in the ferroelectric material film may vary depending on a type of the ferroelectric material included in the ferroelectric material film.

When the ferroelectric material film includes hafnium oxide, the dopant contained in the ferroelectric material film may include, for example, at least one of gadolinium (Gd), silicon (Si), zirconium (Zr), aluminum (Al), or yttrium (Y).

When the dopant is aluminum (Al), the ferroelectric material film may contain about 3 to about 8 at% (atomic %) of aluminum. In this connection, a content of the dopant may be a content of aluminum based on a sum of hafnium and aluminum.

When the dopant is silicon (Si), the ferroelectric material film may contain about 2 to about 10 at% of silicon. When the dopant is yttrium (Y), the ferroelectric material film may contain about 2 to about 10 at% yttrium. When the dopant is gadolinium (Gd), the ferroelectric material film may contain about 1 to about 7 at% gadolinium. When the dopant is zirconium (Zr), the ferroelectric material film may contain about 50 to about 80 at% zirconium.

The paraelectric material film may have paraelectric properties. The paraelectric material film may include, for example, at least one of silicon oxide and metal oxide having a high dielectric constant. Although the metal oxide contained in the paraelectric material film may include, for example, at least one of hafnium oxide, zirconium oxide or aluminum oxide. However, the present disclosure is not limited thereto.

The ferroelectric material film and the paraelectric material film may include the same material. The ferroelectric material film may have ferroelectric properties, but the paraelectric material film may not have the ferroelectric properties. For example, when each of the ferroelectric material film and the paraelectric material film includes hafnium oxide, a crystal structure of hafnium oxide contained in the ferroelectric material film is different from a crystal structure of hafnium oxide contained in the paraelectric material film.

The ferroelectric material film may have a thickness sized to exhibit ferroelectric properties. Although the thickness of the ferroelectric material film may be, for example, in a range of about 0.5 nm to about 10 nm, the present disclosure is not limited thereto. Because a critical thickness exhibiting the ferroelectric properties may vary based on a type of the ferroelectric material, the thickness of the ferroelectric material film may vary depending on the type of the ferroelectric material.

In one example, the first gate insulating film GI may include one ferroelectric material film. In another example, the first gate insulating film GI may include a plurality of ferroelectric material films spaced apart from each other. The first gate insulating film GI may have a stack film structure in which a plurality of ferroelectric material films and a plurality of paraelectric material films are alternately stacked with each other.

A gate capping pattern GE_CAP may be disposed on the first gate electrode GE. The first lower wiring structure 110ST may be disposed on the first gate electrode GE. It is illustrated that the first lower wiring structure 110ST is not connected to the first gate electrode GE. However, the present disclosure is not limited thereto.

A fourth interlayer insulating film 180 may be disposed on the gate capping pattern GE_CAP. The fourth interlayer insulating film 180 may include, for example, at least one of silicon oxide, silicon nitride, silicon oxynitride, or a low dielectric constant material.

The first lower wiring line 110 may be disposed in the fourth interlayer insulating film 180. The fourth interlayer insulating film 180 may correspond to the first interlayer insulating film 150 of FIGS. 2 and 3.

The first lower wiring line 110, the first upper wiring structure 210ST, the first etch stop film 155, and the first wiring upper air gap 110_UAG may be disposed on the fourth interlayer insulating film 180. The detailed descriptions of the first lower wiring line 110, the first upper wiring structure 210ST, the first etch stop film 155, and the first wiring upper air gap 110_UAG may be substantially the same as those as set forth above with reference to FIGS. 1 - 21.

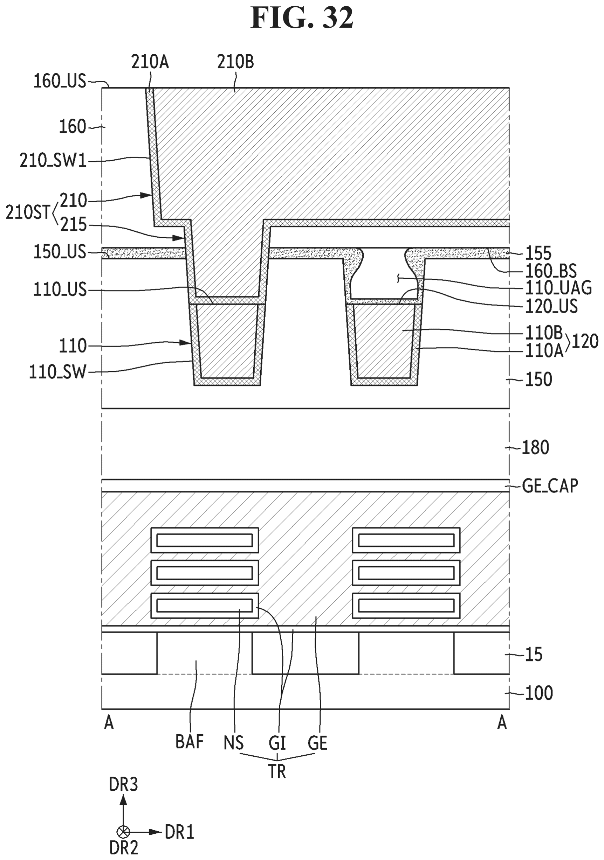

FIG. 32 is a diagram for illustrating a semiconductor device according to some implementations. For convenience of descriptions, the following descriptions are based on differences thereof from descriptions using FIG. 31.

Referring to FIG. 32, in the semiconductor device according to some implementations, a transistor TR may include a nanosheet NS, the first gate electrode GE surrounding the nanosheet NS, and the first gate insulating film GI between the nanosheet NS and the first gate electrode GE.

The nanosheet NS may be disposed on a lower fin-shaped pattern BAF. The nanosheet NS may be spaced apart from the lower fin-shaped pattern BAF in the third direction DR3. The transistor TR is shown as including three nanosheets NS spaced apart from each other in the third direction DR3. However, the present disclosure is not limited thereto. The number of the nanosheets NS arranged in the third direction DR3 and disposed on the lower fin-shaped pattern BAF may be at least four or may be smaller than three.

Each of the lower fin-shaped pattern BAF and the nanosheet NS may include, for example, silicon or germanium as an elemental semiconductor material. Each of the lower fin-shaped pattern BAF and the nanosheet NS may include a compound semiconductor. For example, each of the lower fin-shaped pattern BAF and the nanosheet NS may include a group IV-IV compound semiconductor or a group III-V compound semiconductor. The lower fin-shaped pattern BAF and the nanosheet NS may include the same material or may include different materials.

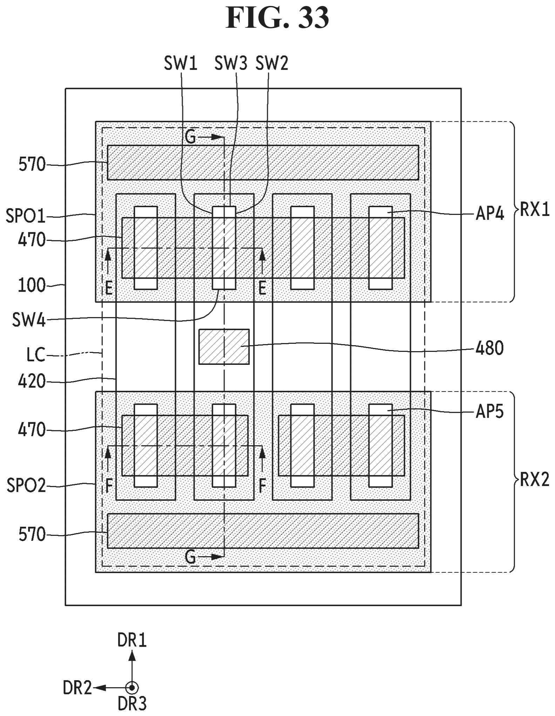

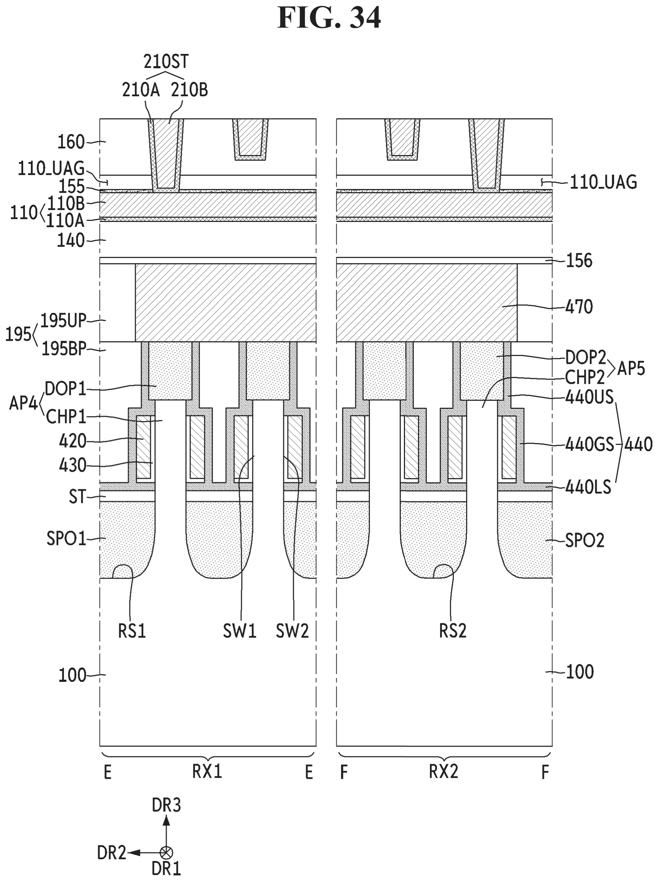

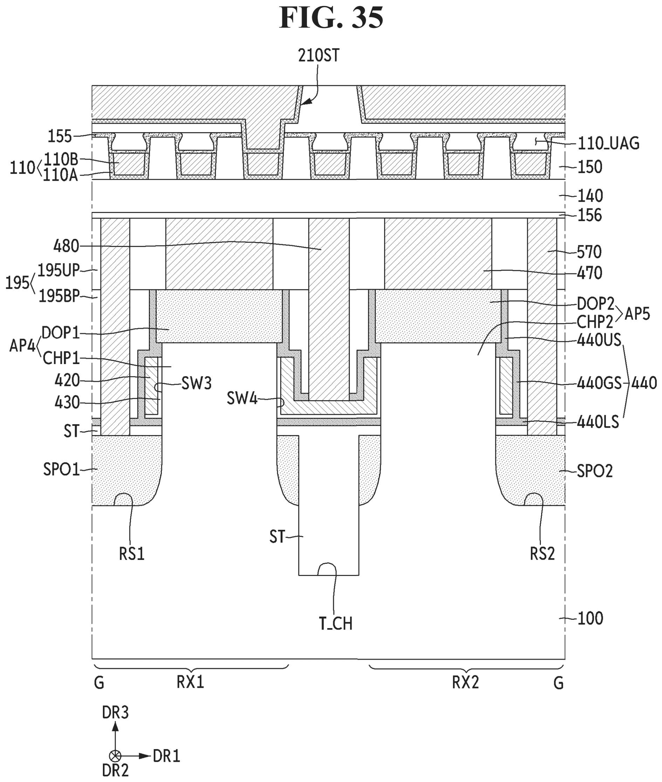

FIGS. 33 - 35 are diagrams for illustrating a semiconductor device according to some implementations. For reference, FIG. 33 is a plan view for illustrating a semiconductor device according to some implementations. FIG. 34 is a cross-sectional view taken along lines E-E and F-F of FIG. 33. FIG. 35 is a cross-sectional view taken along a line G-G of FIG. 33.

Referring to FIG. 33 to FIG. 35, a logic cell LC may be disposed on a substrate 100. The logic cell LC may mean a logic element (for example, an inverter or a flip-flop) that performs a specific function. The logic cell LC may include vertical transistors (Vertical FETs) constituting a logic element, and lines connecting the vertical transistors to each other.

The logic cell LC on the substrate 100 may include a first active area RX1 and a second active area RX2. For example, the first active area RX1 may be a PMOSFET area, while the second active area RX2 may be an NMOSFET area. The first and second active areas RX1 and RX2 may be defined by a trench T_CH formed in a top of the substrate 100. The first and second active areas RX1 and RX2 may be spaced apart from each other in the first direction DR1.

A first lower epitaxial pattern SPO1 may be disposed on the first active area RX1, while a second lower epitaxial pattern SPO2 may be disposed on the second active area RX2. In the plan view, the first lower epitaxial pattern SPO1 may overlap with the first active area RX1, while the second lower epitaxial pattern SPO2 may overlap with the second active area RX2. The first and second lower epitaxial patterns SPO1 and SPO2 may be epitaxial patterns formed using a selective epitaxial growth process. The first lower epitaxial pattern SPO1 may be disposed in a first recess area RS1 of the substrate 100, while the second lower epitaxial pattern SPO2 may be disposed in a second recess area RS2 of the substrate 100.

The fourth active patterns AP4 may be disposed on the first active area RX1, while the fifth active patterns AP5 may be disposed on the second active area RX2. Each of the fourth and fifth active patterns AP4 and AP5 may have a vertically protruding fin shape. In the plan view, each of the fourth and fifth active patterns AP4 and AP5 may have a bar shape extending in the first direction DR1. The fourth active patterns AP4 may be arranged along the second direction DR2, while the fourth active patterns AP5 may be arranged along the second direction DR2.

Each of the fourth active patterns AP4 may include a first channel pattern CHP1 vertically protruding from the first lower epitaxial pattern SPO1 and a first upper epitaxial pattern DOP1 on the first channel pattern CHP1. Each of the fourth active patterns AP5 may include a second channel pattern CHP2 vertically protruding from the second lower epitaxial pattern SPO2 and a second upper epitaxial pattern DOP2 on the second channel pattern CHP2.

An element isolation film ST may be disposed on the substrate 100 so as to fill the trench T_CH. The element isolation film ST may cover top faces of the first and second lower epitaxial patterns SPO1 and SPO2. The fourth and fifth active patterns AP4 and AP5 may protrude vertically upwardly beyond the element isolation film ST.

A plurality of second gate electrodes 420 extending parallel to each other and in the first direction DR1 may be disposed on the device isolation film ST. The second gate electrodes 420 may be arranged along the second direction DR2. The second gate electrode 420 may surround the first channel pattern CHP1 of the fourth active pattern AP4 and may surround the second channel pattern CHP2 of the fifth active pattern AP5. For example, the first channel pattern CHP1 of the fourth active pattern AP4 may have first to fourth sidewalls SW1 to SW4. The first and second sidewalls SW1 and SW2 may face each other in the second direction DR2, while the third and fourth sidewalls SW3 and SW4 may face each other in the first direction DR1. The second gate electrode 420 may be disposed on the first to fourth sidewalls SW1 to SW4. In other words, the second gate electrode 420 may surround the first to fourth sidewalls SW1 to SW4.

The second gate insulating film 430 may be interposed between the second gate electrode 420 and each of the first and second channel patterns CHP1 and CHP2. The second gate insulating film 430 may cover a bottom face of the second gate electrode 420 and an inner sidewall of the second gate electrode 420. For example, the second gate insulating film 430 may directly cover the first to fourth sidewalls SW1 to SW4 of the fourth active pattern AP4.

First and second upper epitaxial patterns DOP1 and DOP2 may protrude vertically upwardly beyond the second gate electrode 420. A vertical level of a top face of the second gate electrode 420 may be lower than a vertical level of a bottom face of each of the first and second upper epitaxial patterns DOP1 and DOP2. In other words, each of the fourth and fifth active patterns AP4 and AP5 may protrude vertically from the substrate 100 and extend through the second gate electrode 420.

The semiconductor device according to some implementations may include vertical transistors in which carriers migrate in the third direction DR3. For example, when a voltage is applied to the second gate electrode 420 and thus the transistor is turned "on", the carriers may move from the lower epitaxial pattern SOP1 and SOP2 to the upper epitaxial patterns DOP1 and DOP2 via the channel patterns CHP1 and CHP2, respectively. In the semiconductor device according to some implementations, the second gate electrode 420 may surround an entirety of the sidewalls SW1 to SW4 of the channel patterns CHP1 and CHP2. The transistor according to the present disclosure may be a three-dimensional electric field effect transistor (for example, a VFET) having a gate all around structure. Since the gate surrounds the channel, the semiconductor device according to some implementations may have excellent electrical characteristics.

A spacer 440 covering the second gate electrodes 420 and the fourth and fifth active patterns AP4 and AP5 may be disposed on the device isolation film ST. The spacer 440 may include a silicon nitride or a silicon oxynitride. The spacer 440 may include a lower spacer 440LS, an upper spacer 440US, and a gate spacer 440GS between the lower and upper spacers 440LS and 440US.

The lower spacer 440LS may directly cover an upper surface of the element isolation film ST. The second gate electrodes 420 may be spaced apart from the element isolation film ST in the third direction DR3 via the lower spacer 440LS. The gate spacer 440GS may cover an upper surface and an outer sidewall of each of the second gate electrodes 420. The upper spacer 440 may cover the first and second upper epitaxial patterns DOP1 and DOP2. However, the upper spacer 440US may not cover the upper surfaces of the first and second upper epitaxial patterns DOP1 and DOP2 but may expose the upper surfaces of the first and second upper epitaxial patterns DOP1 and DOP2.

A first portion 195BP of a fifth interlayer insulating film 195 may be disposed on the spacer 440. An upper surface of the first portion 195BP of the fifth interlayer insulating film 195 may be substantially coplanar with upper surfaces of the first and second upper epitaxial patterns DOP1 and DOP2. A second portion 195UP of the fifth interlayer insulating film 195 and the sixth interlayer insulating film 140 may be sequentially stacked on the first portion 195BP of the fifth interlayer insulating film 195. The first portion 195BP of the fifth interlayer insulating film 195 and the second portion 195UP of the fifth interlayer insulating film 195 may be included in the fifth interlayer insulating film 195. The second portion 195UP of the fifth interlayer insulating film 195 may cover the upper surfaces of the first and second upper epitaxial patterns DOP1 and DOP2.

At least one first source/drain contact 470 may be disposed to extend through the second portion 195UP of the fifth interlayer insulating film 195 so as to contact the first and second upper epitaxial patterns DOP1 and DOP2. At least one second source/drain contact 570 may be disposed to sequentially extend through the fifth interlayer insulating film 195, the lower spacer 440LS, and the element isolation film ST so as to contact the first and second lower epitaxial patterns SPO1 and SPO2. A gate contact 480 may be provided to sequentially extend through the second portion 195UP of the fifth interlayer insulating film 195, the first portion 195BP of the fifth interlayer insulating film 195, and the gate spacer 440GS so as to contact the second gate electrode 420.

A second etch stop film 156 may be additionally disposed between the second portion 195UP of the fifth interlayer insulating film and the sixth interlayer insulating film 140.

The first lower wiring line 110, the first upper wiring structure 210ST, the first etch stop film 155, and the first wiring upper air gap 110_UAG may be disposed on the sixth interlayer insulating film 140. The detailed descriptions of the first lower wiring line 110, the first upper wiring structure 210ST, the first etch stop film 155, and the first wiring upper air gap 110_UAG may be substantially the same as those as set forth above with reference to FIGS. 1 - 21.

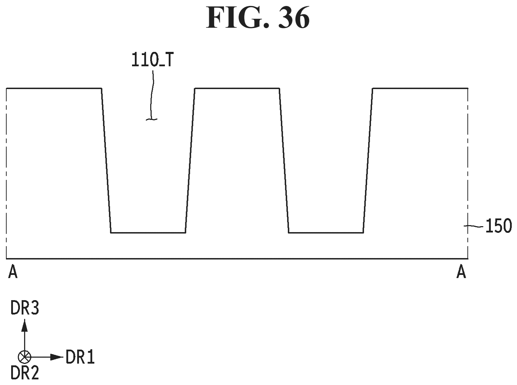

FIGS. 36 - 42 are diagrams illustrating for illustrating intermediate structures corresponding to intermediate steps of a method for manufacturing a semiconductor device according to some implementations.

Referring to FIG. 36, the first interlayer insulating film 150 may be formed on the substrate (100 of FIGS. 24 and 25).

A lower wiring trench 110_T may be formed in the first interlayer insulating film 150. The first interlayer insulating film 150 having the lower wiring trench 110_T defined therein may be formed.

The lower wiring trench 110_T may extend in an elongate manner in the second direction DR2.

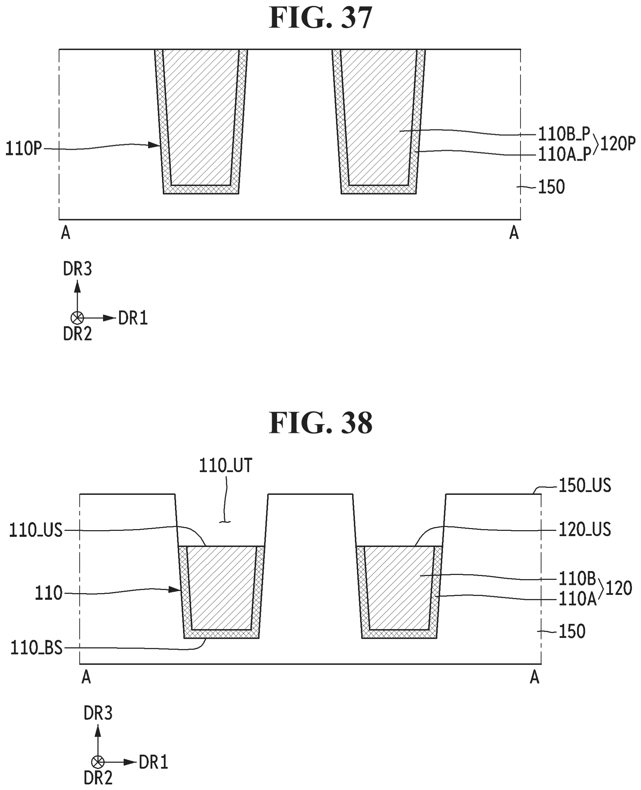

Referring to FIGS. 36 and 37, a first pre-lower wiring line 110P and a second pre-lower wiring line 120P may be formed in the lower wiring trench 110_T.

The first pre-lower wiring line 110P and the second pre-lower wiring line 120P may fill the lower wiring trench 110_T.

Each of the first pre-lower wiring line 110P and the second pre-lower wiring line 120P may include a first pre-lower wiring barrier film 110A_P and a first pre-lower wiring filling film 110B_P.

Referring to FIGS. 37 and 38, a portion of the first pre-lower wiring line 110P and a portion of the second pre-lower wiring line 120P may be removed, and thus the first lower wiring line 110 and the second lower wiring line 120 extending in the second direction DR2 may be formed in the first interlayer insulating film 150.

The first interlayer insulating film 150 may cover the sidewall of the first lower wiring line 110 and the sidewall of the second lower wiring line 120. Each of the first lower wiring line 110 and the second lower wiring line 120 may include a lower wiring barrier film 110A and a lower wiring filling film 110B.

A portion of the first pre-lower wiring line 110P and a portion of the second pre-lower wiring line 120P may be removed to form an upper wiring trench 110_UT in the first interlayer insulating film 150. The wiring upper trench 110_UT may extend in an elongate manner in the second direction DR2. In other words, while the first lower wiring line 110 and the second lower wiring line 120 are formed, the wiring upper trench 110_UT may be formed. The bottom surface of the wiring upper trench 110_UT may be the first surface 110_US of the first lower wiring line 110 or the first surface 120_US of the second lower wiring line 120.

A vertical level of each of the first surface 110_US of the first lower wiring line 110 and the first surface 120_US of the second lower wiring line 120 may be lower than a vertical level of the upper surface 150_US of the first interlayer insulating film 150. For example, the vertical length from the second surface 110_BS of the first lower wiring line 110 to the upper surface 150_US of the first interlayer insulating film 150 is greater than the vertical length from the second surface 110_BS of the first lower wiring line 110 to the bottom surface of the wiring upper trench 110_UT.

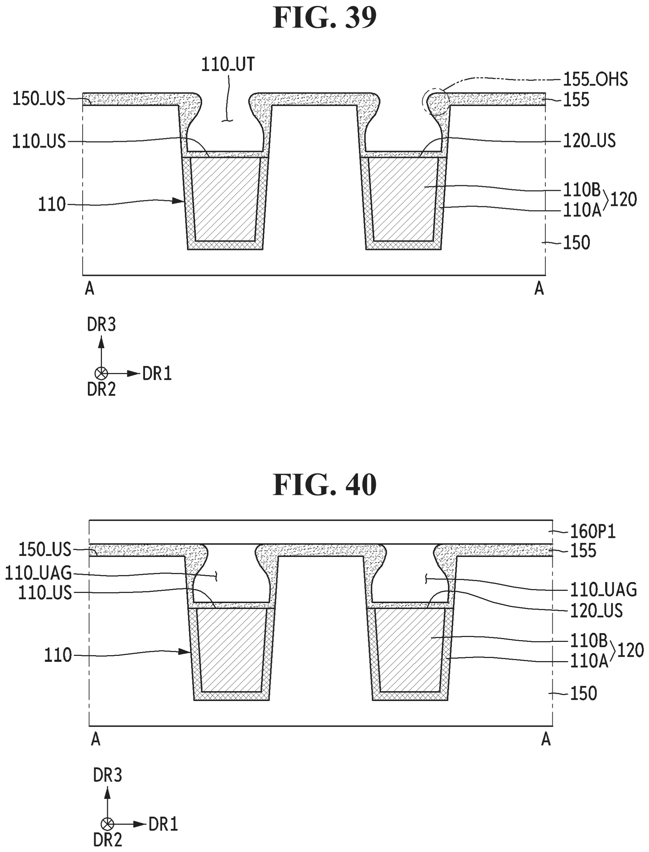

Referring to FIG. 39, the first etch stop film 155 may be formed on the first interlayer insulating film 150, the first lower wiring line 110, and the second lower wiring line 120.

The first etch stop film 155 may be formed along the upper surface 150_US of the first interlayer insulating film 150 and the sidewalls and the bottom surface of the wiring upper trench 110_UT.

For example, the first etch stop film 155 may be formed using a deposition method having poor step coverage. Accordingly, the overhang structure 155_OHS of the first etch stop film 155 may be formed at a point where the upper surface 150_US of the first interlayer insulating film 150 and the sidewall of the wiring upper trench 110_UT meet each other. As the overhang structure 155_OHS of the first etch stop film 155 is formed, a width of the uppermost surface of the wiring upper trench 110_UT is reduced.

Referring to FIGS. 39 and 40, a first portion 160P1 of the second interlayer insulating film 160 may be formed on the first etch stop film 155.

Since a width of the uppermost surface of the wiring upper trench 110_UT is narrowed, the first portion 160P1 of the second interlayer insulating film 160 may not fill the wiring upper trench 110_UT. Because the first portion 160P1 of the second interlayer insulating film 160 does not fill the wiring upper trench 110_UT, the first wiring upper air gap 110_UAG may be formed. The first wiring upper air gap 110_UAG may be formed between the first portion 160P1 of the second interlayer insulating film and the first etch stop film 155.

The first wiring upper air gap 110_UAG may extend in the second direction DR2 and along the first surface 110_US of the first lower wiring line 110 and the first surface 120_US of the second lower wiring line 120.

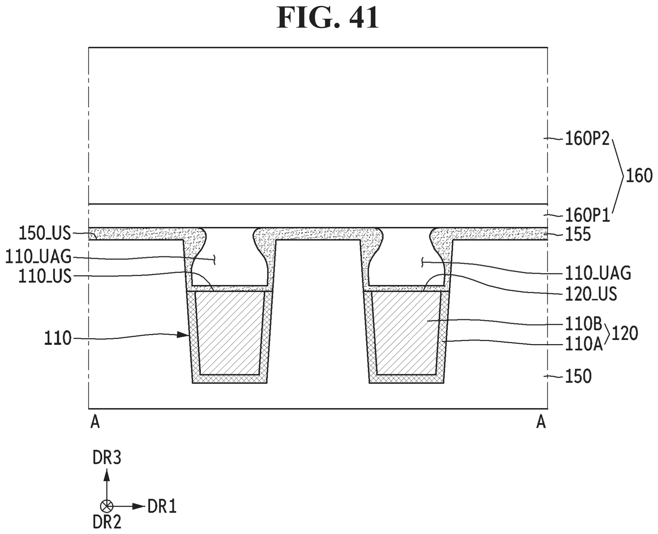

Referring to FIG. 41, a second portion 160P2 of the second interlayer insulating film 160 may be formed on the first portion 160P1 of the second interlayer insulating film 160.

The second interlayer insulating film 160 including the first portion 160P1 of the second interlayer insulating film and the second portion 160P2 of the second interlayer insulating film 160 may be formed on the first etch stop film 155.

When the first portion 160P1 of the second interlayer insulating film and the second portion 160P2 of the second interlayer insulating film include different materials, the first portion 160P1 of the second interlayer insulating film 160 may be the second lower interlayer insulating film (160BP of FIG. 7), and the second portion 160P2 of the second interlayer insulating film 160 may be the second upper interlayer insulating film (160UP of FIG. 7).

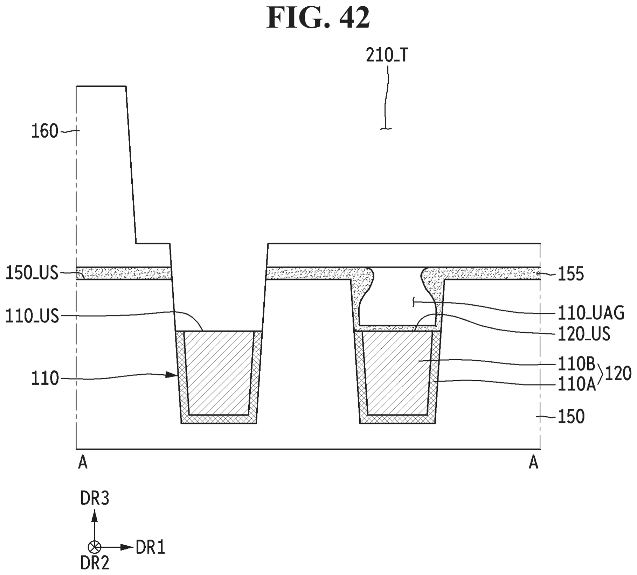

Referring to FIG. 42, an upper wiring trench 210_T may be formed in the second interlayer insulating film 160.

The upper wiring trench 210_T may extend through the first etch stop film 155. The upper wiring trench 210_T may expose the first surface 110_US of the first lower wiring line 110.

Next, referring to FIGS. 2 and 3, the first upper wiring structure 210 may be formed in the second interlayer insulating film 210. The first upper wiring structure 210 may be formed in the upper wiring trench 210_T. The first upper wiring structure 210 may fill the upper wiring trench 210_T.

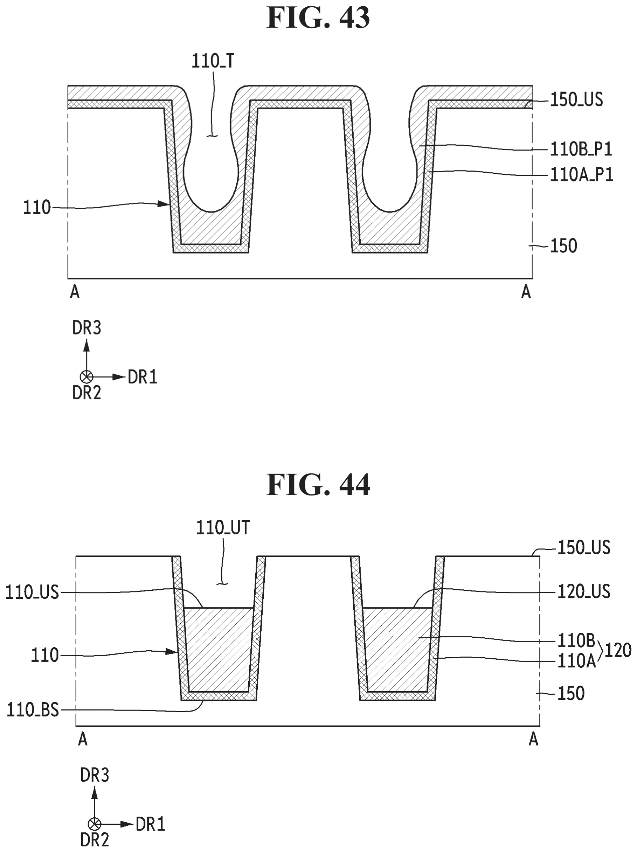

FIGS. 43 and 44 are diagrams for illustrating intermediate structures corresponding to intermediate steps of a method for manufacturing a semiconductor device according to some implementations. FIG. 43 may be a manufacturing process performed after FIG. 36.

Referring to FIG. 43, a second pre-lower wiring barrier film 110A_P1 may be formed along the upper surface 150_US of the first interlayer insulating film 150 and the sidewalls and the bottom surface of the lower wiring trench 110_T.

The second pre-lower wiring filling film 110B_P1 may be formed on the second pre-lower wiring barrier film 110A_P1. The second pre-lower wiring filling film 110B_P1 may have a non-uniform thickness. The second pre-lower wiring filling film 110B_P1 may include copper (Cu). However, implementations of the present disclosure are not limited thereto.

Referring to FIGS. 43 and 44, a portion of the second pre-lower wiring filling film 110B_P1 disposed on the upper surface 150_US of the first interlayer insulating film 150 may flow into the lower wiring trench 110_T using a reflow process.

Accordingly, the lower wiring filling film 110B may be formed.

Subsequently, the remainder of the second pre-lower wiring filling film 110B_P1 disposed on the upper surface 150_US of the first interlayer insulating film 150 may be removed. In addition, the second pre-lower wiring filling film 110B_P1 disposed on the upper surface 150_US of the first interlayer insulating film 150 may be removed. As a result, the first lower wiring line 110 and the second lower wiring line 120 may be formed.

Subsequently, the manufacturing process as described using FIGS. 39 - 42 may be performed.

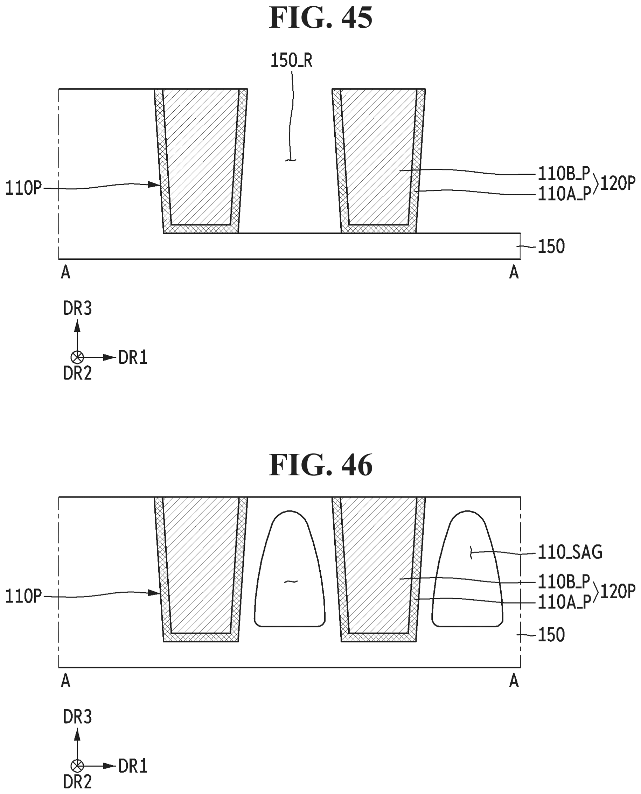

FIGS. 45 and 46 are diagrams for illustrating intermediate structures corresponding to intermediate steps of a method for manufacturing a semiconductor device according to some implementations. FIG. 45 may be a manufacturing process performed after FIG. 37.

Referring to FIG. 45, a portion of the first interlayer insulating film 150 may be removed to form a wiring side recess 150_R.

The wiring side recess 150_R may be formed between the first pre-lower wiring line 110P and the second lower wiring line 120P. The wiring side recess 150_R may extend in the second direction DR2 and along the first pre-lower wiring line 110P and the second lower wiring line 120P.

Referring to FIGS. 45 and 46, an additional first interlayer insulating film 150 may be formed in the wiring side recess 150_R, and thus the wiring sidewall air gap 110_SAG may be formed in the first interlayer insulating film 150.

The wiring sidewall air gap 110_SAG may be formed on the sidewall of the first pre-lower wiring line 110P. The wiring sidewall air gap 110_SAG may extend in an elongate manner in the second direction DR2.

Subsequently, the manufacturing process described above using FIGS. 38 - 42 may be performed.

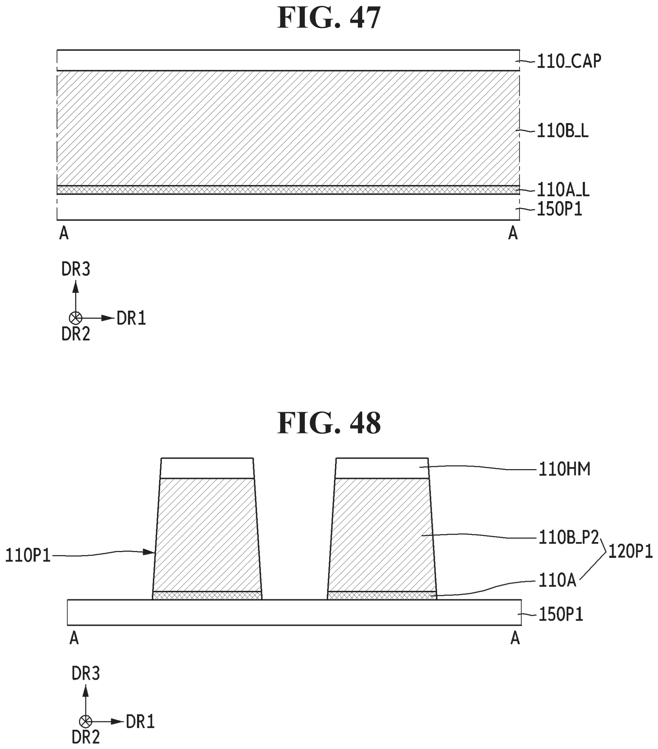

FIGS. 47 - 50 are diagrams illustrating for illustrating intermediate structures corresponding to intermediate steps of a method for manufacturing a semiconductor device according to some implementations.

Referring to FIG. 47, a first portion 150P1 of the first interlayer insulating film 150 may be formed on the substrate (100 of FIGS. 24 and 25).

A third pre-lower wiring barrier film 110A_L and a third pre-lower wiring filling film 110B_L may be sequentially formed on the first portion 150P1 of the first interlayer insulating film 150. The third pre-lower wiring barrier film 110A_L and the third pre-lower wiring filling film 110B_L may be formed on the substrate (100 of FIGS. 24 and 25). The third pre-lower wiring barrier film 110A_L and the third pre-lower wiring filling film 110B_L may be lower wiring films.

A wiring capping film 110_CAP may be formed on the third pre-lower wiring filling film 110B_L.

Referring to FIGS. 47 and 48, the third pre-lower wiring barrier film 110A_L and the third pre-lower wiring filling film 110B_L may be patterned to form a third pre-lower wiring line 110P1 and a fourth pre-lower wiring line 120P1.

The third pre-lower wiring line 110P1 and the fourth pre-lower wiring line 120P1 may be formed on the first portion 150P1 of the first interlayer insulating film 150. Each of the third pre-lower wiring line 110P1 and the fourth pre-lower wiring line 120P1 may extend in the second direction DR2. Each of the third pre-lower wiring line 110P1 and the fourth pre-lower wiring line 120P1 may include a lower wiring barrier film 110A and a third pre-lower wiring filling film 110B_P2.

While the third pre-lower wiring line 110P1 and the fourth pre-lower wiring line 120P1 are formed, the wiring capping film 110_CAP may be patterned. As a result, a lower wiring hard mask pattern 110HM may be formed on the third pre-lower wiring line 110P1 and the fourth pre-lower wiring line 120P1.

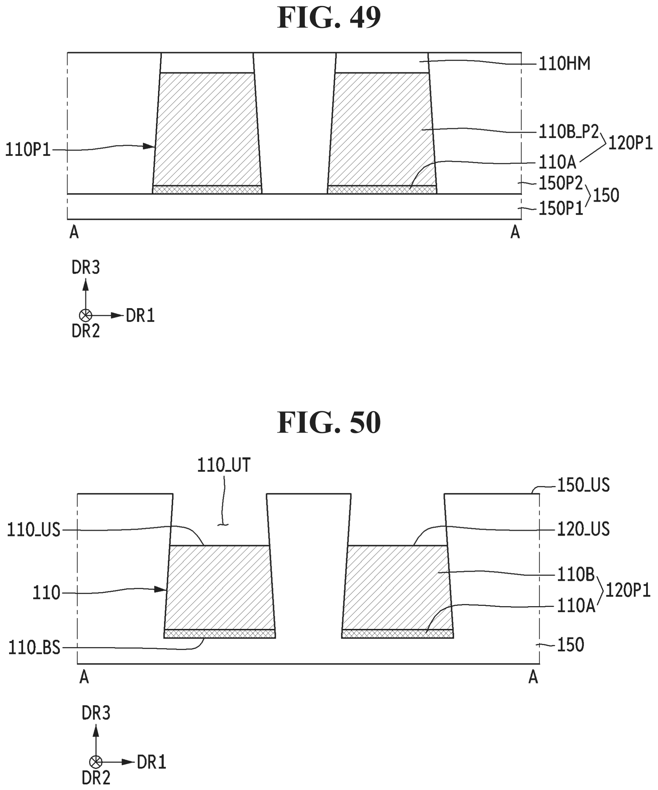

Referring to FIG. 49, a second portion 150P2 of the first interlayer insulating film 150 may be formed on the first portion 150P1 of the first interlayer insulating film 150.

The first interlayer insulating film 150 including the first portion 150P1 of the first interlayer insulating film and the second portion 150P2 of the first interlayer insulating film 150 may be formed on the substrate 100 (see FIGS. 24 and 25).

The second portion 150P2 of the first interlayer insulating film 150 may cover the sidewall of the third pre-lower wiring line 110P1 and the sidewall of the fourth pre-lower wiring line 120P1. That is, the first interlayer insulating film 150 may cover the sidewall of the third pre-lower wiring line 110P1 and the sidewall of the fourth pre-lower wiring line 120P1.

Referring to FIGS. 49 and 50, the first lower wiring line 110 and the second lower wiring line 120 may be formed by removing a portion of each of the third pre-lower wiring line 110P1 and the fourth pre-lower wiring line 120P1.

More specifically, the lower wiring hard mask pattern 110HM may be removed to expose the third pre-lower wiring line 110P1 and the fourth pre-lower wiring line 120P1. Subsequently, a portion of the third pre-lower wiring filling film 110B_P2 may be removed to form the lower wiring filling film 110B. As a result, the first lower wiring line 110 and the second lower wiring line 120 may be formed.

A portion of the third pre-lower wiring filling film 110B_P2 and the lower wiring hard mask pattern 110HM may be removed to form a wiring upper trench 110_UT in the first interlayer insulating film 150.

The thickness of the lower wiring hard mask pattern 110HM is sufficiently thick, such that the third pre-lower wiring filling film 110B_P2 may be the lower wiring filling film 110B (see FIG. 9).

Subsequently, the manufacturing process described above using FIGS. 39 - 42 may be performed.

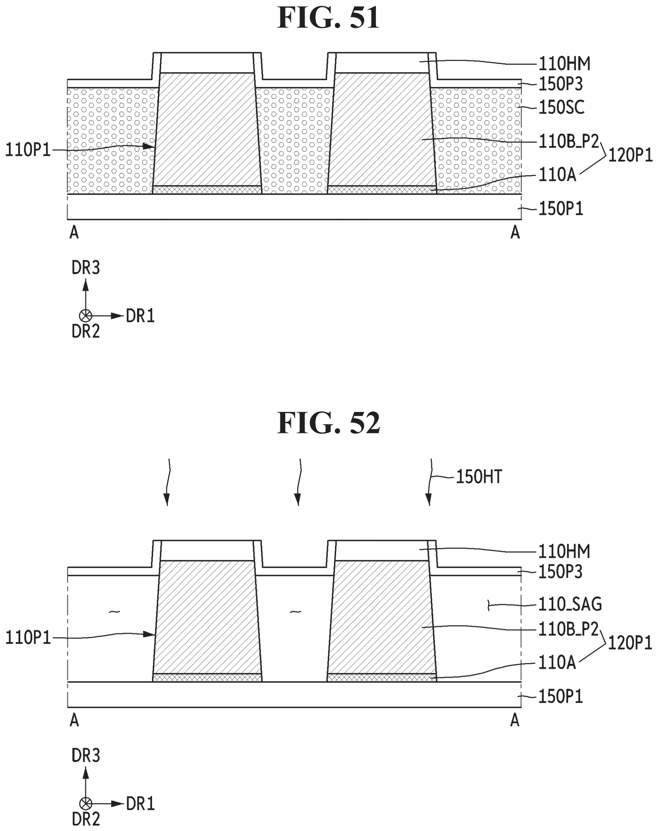

FIGS. 51 - 53 are diagrams illustrating for illustrating intermediate structures corresponding to intermediate steps of a method for manufacturing a semiconductor device according to some implementations. FIG. 51 may be a manufacturing process performed after FIG. 48.

Referring to FIG. 51, a first sacrificial material film 150SC may be formed between a third pre-lower wiring line 110P1 and a fourth pre-lower wiring line 120P1 adjacent to each other in the first direction DR1.

The first sacrificial material film 150SC may be formed on the first portion 150P1 of the first interlayer insulating film 150. The first sacrificial material film 150SC may cover a sidewall of the third pre-lower wiring line 110P1 and a sidewall of the fourth pre-lower wiring line 120P1. The first sacrificial material film 150SC is not formed on the upper surface of the lower wiring hard mask pattern 110HM.

The first sacrificial material film 150SC may include a polymer including carbon (C) and hydrogen (H). For example, the first sacrificial material film 150SC may further include at least one of oxygen (O) or nitrogen (N) in the polymer including carbon (C) and hydrogen (H).

The first sacrificial material film 150SC may be formed in a deposition process or a coating process. For example, when heat of 150° C or higher is applied to the first sacrificial material film 150SC, the first sacrificial material film 150SC may be decomposed into monomers. In another example, when ultraviolet rays (UV) are irradiated to the first sacrificial material film 150SC, the first sacrificial material film 150SC may be decomposed into monomers.

Subsequently, a third portion 150P3 of the first interlayer insulating film 150 may be formed on the first sacrificial material film 150SC, the third pre-lower wiring line 110P1, and the fourth pre-lower wiring line 120P1.

Referring to FIGS. 51 and 52, the first sacrificial material film 150SC may be removed using a first post-treatment process 150HT.

Accordingly, the wiring sidewall air gap 110_SAG may be formed on the sidewall of the third pre-lower wiring line 110P1 and the sidewall of the fourth pre-lower wiring line 120P1.

For example, the first post-treatment process 150HT may include a heat treatment process. In another example, the first post-treatment process 150HT may include an ultraviolet irradiation process. While the first post-treatment process 150HT is performed, the first sacrificial material film 150SC may be decomposed into monomers which in turn are discharged through a pinhole defined in the third portion 150P3 of the first interlayer insulating film 150.

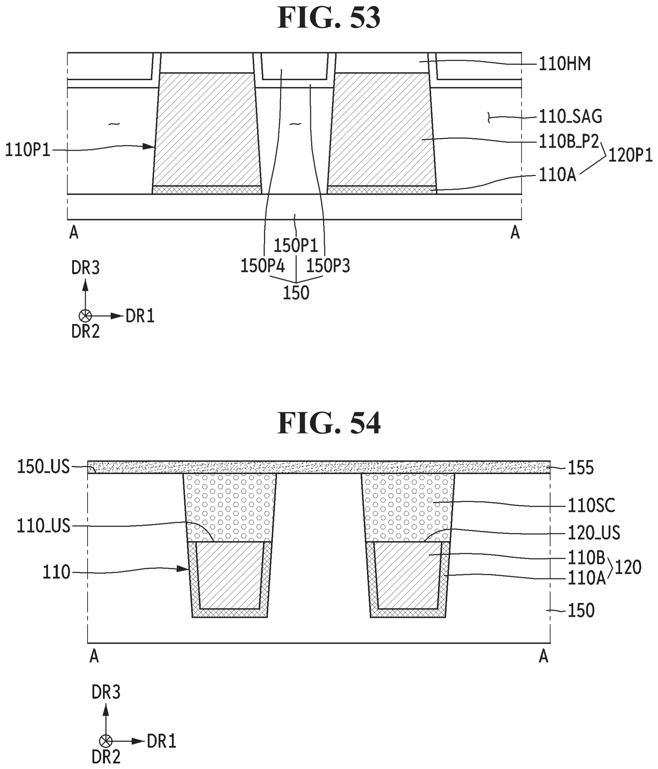

Referring to FIG. 53, a fourth portion 150P4 of the first interlayer insulating film 150 may be formed on the third portion 150P3 of the first interlayer insulating film 150.

The fourth portion 150P4 of the first interlayer insulating film 150 may not be formed on the upper surface of the lower wiring hard mask pattern 110HM. Accordingly, the first interlayer insulating film 150 including the first portion 150P1 of the first interlayer insulating film 150, the third portion 150P3 of the first interlayer insulating film 150, and the fourth portion 150P4 of the first interlayer insulating film 150 may be formed.

Subsequently, the manufacturing process described above using FIG. 50 and FIGS. 39 - 42 may be performed.

Before the first sacrificial material film 150SC is formed, a fifth portion of the first interlayer insulating film 150 may be formed along the sidewall of the third pre-lower wiring line 110P1 and the sidewall of the fourth pre-lower wiring line 120P1. In this case, in FIG. 53, the wiring sidewall air gap 110_SAG may not contact the sidewall of the third pre-lower wiring line 110P1 and the sidewall of the fourth pre-lower wiring line 120P1.

In addition, while the fourth portion 150P4 of the first interlayer insulating film 150 is formed, the fifth portion of the first interlayer insulating film 150 may be formed along the sidewall of the third pre-lower wiring line 110P1 and the sidewall of the fourth pre-lower wiring line 120P1. While the fourth portion 150P4 of the first interlayer insulating film 150 is formed, a portion of the fourth portion 150P4 of the first interlayer insulating film 150 may pass through a pinhole included in the third portion 150P3 of the first interlayer insulating film 150. The fourth portion 150P4 of the first interlayer insulating film 150 having passed through the pinhole included in the third portion 150P3 of the first interlayer insulating film 150 may constitute a fifth portion of the first interlayer insulating film 150.

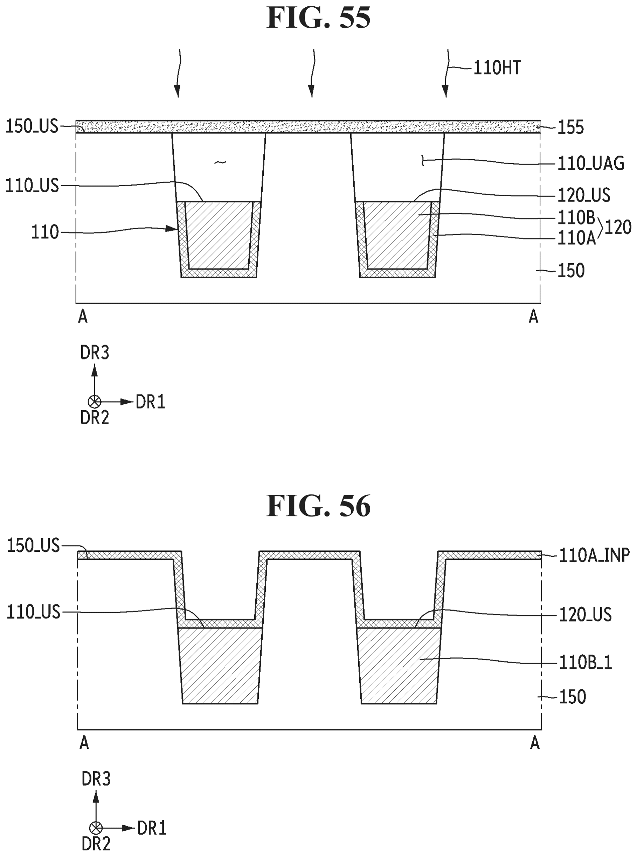

FIGS. 54 and 55 are diagrams for illustrating intermediate structures corresponding to intermediate steps of a method for manufacturing a semiconductor device according to some implementations. FIG. 54 may be a manufacturing process performed after FIG. 38.

Referring to FIG. 54, a second sacrificial material film 110SC may be formed in the wiring upper trench 110_UT.

The second sacrificial material film 110SC may fill the wiring upper trench 110_UT. The description of the material included in the second sacrificial material film 110SC may be substantially the same as the description of the material included in the first sacrificial material film 150SC of FIG. 51.

Subsequently, the first etch stop film 155 may be formed on the first interlayer insulating film 150 and the second sacrificial material film 110SC.

Referring to FIGS. 54 and 55, the second sacrificial material film 110SC may be removed using a second post-treatment process 110HT.

Accordingly, the first wiring upper air gap 110_UAG may be formed between the first etch stop film 155 and the first lower wiring line 110 and between the first etch stop film 155 and the second lower wiring line 120.

The description of the second post-treatment process 110HT may be substantially the same as the description of the first post-treatment process 150HT of FIG. 52.

Subsequently, the second interlayer insulating film 160 (see FIG. 12) may be formed on the first etch stop film 155.

Subsequently, the manufacturing process described above using FIG. 42 may be performed.

FIGS. 56 - 58 are diagrams illustrating for illustrating intermediate structures corresponding to intermediate steps of a method for manufacturing a semiconductor device according to some implementations. FIG. 56 may be a manufacturing process performed after FIG. 36.

Referring to FIG. 56, a first lower wiring filling film 110B_1 may be formed in the lower wiring trench 110_T (see FIG. 36).

Subsequently, a pre-lower wiring inserted barrier film 110A_INP may be formed on the first lower wiring filling film 110B_1. The pre-lower wiring inserted barrier film 110A_INP may be formed along the upper surface 150_US of the first interlayer insulating film 150, the sidewalls of the lower wiring trench 110_T, and the upper surface of the first lower wiring filling film 110B_1.

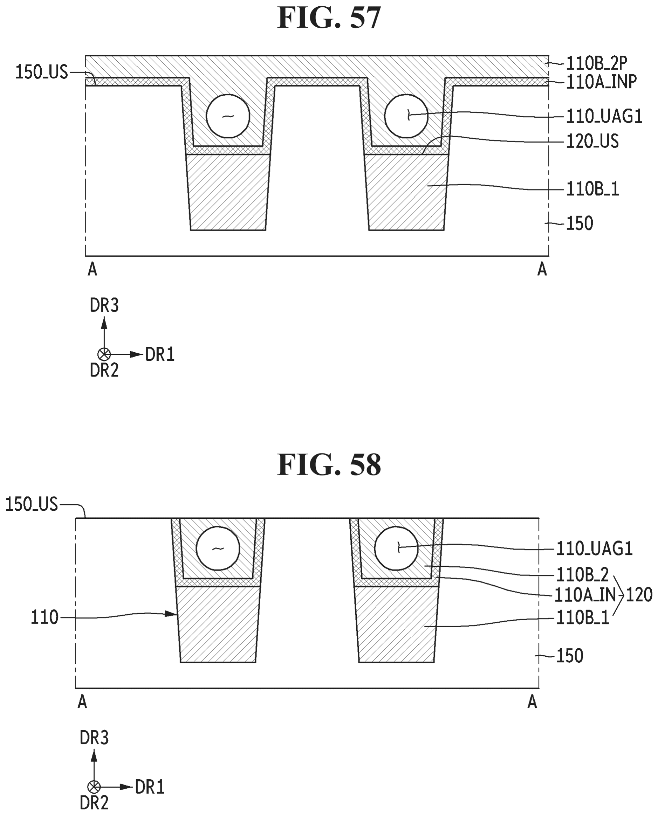

Referring to FIGS. 56 and 57, a fourth pre-lower wiring filling film 110B_2P may be formed on the pre-lower wiring inserted barrier film 110A_INP.

The fourth pre-lower wiring filling film 110B_2P may be formed using, for example, an ion beam sputtering process. In the ion beam sputtering process, the fourth pre-lower wiring filling film 110B_2P may be deposited not only in a direction parallel to the third direction DR3 but also in a direction tilted reactive to the third direction DR3.

Accordingly, the second wiring upper air gap 110_UAG1 may be formed in the fourth pre-lower wiring filling film 110B_2P.

Referring to FIGS. 57 and 58, a portion of each of the fourth pre-lower wiring filling film 110B_2P and the pre-lower wiring inserted barrier film 110A_INP formed on the upper surface 150_US of the first interlayer insulating film 150 may be removed to form the lower wiring inserted barrier film 110A_IN and the second lower wiring filling film 110B_2.

Accordingly, the first lower wiring line 110 and the second lower wiring line 120 including the first lower wiring filling film 110B_1, the lower wiring inserted barrier film 110A_IN, and the second lower wiring filling film 110B_2 may be formed. The second wiring upper air gap 110_UAG1 may be formed in the second lower wiring filling film 110B_2.

Referring to FIG. 14 or 16, the first etch stop film 155 and the second interlayer insulating film 160 may be sequentially formed on the first interlayer insulating film 150, the first lower wiring line 110, and the second lower wiring line 120. Subsequently, the first upper wiring structure 210ST connected to the first lower wiring line 110 may be formed in the second interlayer insulating film 160.

The present disclosure provides a method for manufacturing a semiconductor device. The method comprising: forming a lower wiring line and a first interlayer insulating film on a substrate such that the lower wiring line extends in a first direction and the first interlayer insulating film covers a sidewall of the lower wiring line; forming a wiring upper trench in the first interlayer insulating film while the lower wiring line is formed, wherein a vertical length from a bottom surface of the lower wiring line to an upper surface of the first interlayer insulating film is greater than a vertical length from the bottom surface of the lower wiring line to a bottom surface of the wiring upper trench; forming an etch stop film along the upper surface of the first interlayer insulating film, and a sidewall and the bottom surface of the wiring upper trench; forming a first portion of a second interlayer insulating film on the etch stop film to form a wiring upper air gap between the first portion of the second interlayer insulating film and the etch stop film, wherein the wiring upper air gap extends in the first direction and along an upper surface of the lower wiring line; forming a second portion of the second interlayer insulating film on the first portion of the second interlayer insulating film to form the second interlayer insulating film on the etch stop film; and forming an upper wiring structure in the second interlayer insulating film, wherein the upper wiring structure is connected to the lower wiring line.

In some implementations, the forming of the lower wiring line includes, forming the first interlayer insulating film on the substrate, forming a lower wiring trench in the first interlayer insulating film, wherein the lower wiring trench extends in the first direction, and forming the lower wiring line in the lower wiring trench.

In some implementations, the forming of the lower wiring line includes, forming a lower wiring film on the substrate, patterning the lower wiring layer to form a pre-lower wiring line extending in the first direction, forming the first interlayer insulating film on the substrate, wherein the first interlayer insulating film covers a sidewall of the pre-lower wiring line, and after forming the first interlayer insulating film, removing a portion of the pre-lower wiring line.

The present disclosure provides another method for manufacturing a semiconductor device. The method comprising: forming a lower wiring line and a first interlayer insulating film on a substrate such that the lower wiring line extends in a first direction and the first interlayer insulating film covers a sidewall of the lower wiring line; forming a wiring upper trench in the first interlayer insulating film while the lower wiring line is formed, wherein a vertical length from a bottom surface of the lower wiring line to an upper surface of the first interlayer insulating film is greater than a vertical length from a bottom surface of the lower wiring line to a bottom surface of the wiring upper trench; forming a sacrificial material film on the lower wiring line, wherein the sacrificial material film fills the wiring upper trench; forming an etch stop film on the first interlayer insulating film and the sacrificial material film; after the etch stop film has been formed, removing the sacrificial material film to form a wiring upper air gap between the etch stop film and the lower wiring line, wherein the wiring upper air gap extends in the first direction and along an upper surface of the lower wiring line; forming a second interlayer insulating film on the wiring upper air gap and the etch stop film; and forming an upper wiring structure in the second interlayer insulating film, wherein the upper wiring structure is connected to the lower wiring line.

The present disclosure provides another method for manufacturing a semiconductor device. The method comprising: forming a first interlayer insulating film on a substrate such that a lower wiring trench extending in a first direction is defined in the first interlayer insulating film; forming a first lower wiring filling film filling a portion of the lower wiring trench; forming a lower wiring barrier film on the first lower wiring filling film, wherein the lower wiring barrier film extends along an upper surface of the first lower wiring filling film and a sidewall of the lower wiring trench; forming a second lower wiring filling film on the lower wiring barrier film using ion beam sputtering to form a lower wiring line in the lower wiring trench; forming a wiring upper air gap in the second lower wiring filling film while the second lower wiring filling film is formed; sequentially forming an etch stop film and a second interlayer insulating film on the first interlayer insulating film and the lower wiring line; and forming an upper wiring structure in the second interlayer insulating film, wherein the upper wiring structure is connected to the lower wiring line.

While this specification contains many specific implementation details, these should not be construed as limitations on the scope of any invention or on the scope of what may be claimed, but rather as descriptions of features that may be specific to particular implementations of particular inventions. Certain features that are described in this specification in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

## Claims

1. A semiconductor device comprising:
a lower wiring line (110) including a first surface and a second surface opposite to each other in a first direction (DR3), wherein the lower wiring line (110) extends in a second direction (DR2) perpendicular to the first direction (DR3);
an interlayer insulating film (150, 160) on the first surface of the lower wiring line (110);
an upper wiring structure (210ST) connected to the lower wiring line (110) and including an upper wiring line (210) and an upper wiring via (215), wherein the upper wiring via (215) is between the upper wiring line (210) and the lower wiring line (120); and
at least one of a) and b):
a) a wiring upper air gap (110_UAG) on a bottom surface (160_BS) of the interlayer insulating film (160) and overlapping the first surface of the lower wiring line (110) in the first direction (DR3), wherein the bottom surface (160_BS) of the interlayer insulating film (160) faces the lower wiring line (110), and
b) the wiring upper air gap (110_UAG) in contact with sidewalls (215_SW2) of the upper wiring via (215) and extending in the second direction (DR2), wherein the sidewalls (215_SW2) are opposite to each other in the second direction (DR2),
wherein the upper wiring line (210) extends in a third direction (DR3) perpendicular to the first direction (DR3) and is in the interlayer insulating film (150, 160).

2. The semiconductor device of claim 1, wherein the upper wiring line (210) includes a sidewall (210_SW1, 210_SW2) elongated in the third direction (DR3),
wherein the interlayer insulating film (160) covers an entirety of the sidewall (210_SW1, 210_SW2) of the upper wiring line (210).

3. The semiconductor device of claim 1 or 2, wherein the wiring upper air gap (110_UAG) is on a sidewall (215_SW1, 215_SW2) of the upper wiring via (215).

4. The semiconductor device of any one of claims 1 to 3, comprising an etch stop film (155) between the interlayer insulating film (160) and the lower wiring line (110).

5. The semiconductor device of claim 4, wherein the etch stop film (155) extends along the bottom surface (160_BS) of the interlayer insulating film (160).

6. The semiconductor device of claim 4 or 5, wherein the upper wiring via (215) extends through the etch stop film (155).

7. The semiconductor device of any one of claims 4 to 6, wherein the etch stop film (155) extends along an upper surface (110_US) of the lower wiring line (110).

8. The semiconductor device of any one of claims 4 to 7, wherein the wiring upper air gap (110_UAG) is between the etch stop film (155) and the interlayer insulating film (150, 160).

9. The semiconductor device of any one of claims 4 to 8, wherein the wiring upper air gap (110_UAG) is between the etch stop film (155) and the lower wiring line (110).

10. The semiconductor device of any one of claims 1 to 9, wherein the wiring upper air gap (110_UAG) is in the lower wiring line (110), optionally on the first surface of the lower wiring line (110).

11. The semiconductor device of any one of claims 1 to 10, wherein the lower wiring line (110) includes:
a first lower wiring filling film (110B_1) including the second surface of the lower wiring line (110),
a second lower wiring filling film (110B_2) including the first surface of the lower wiring line (110); and
a lower wiring inserted barrier film (110A_IN) between the first lower wiring filling film (110B_1) and the second lower wiring filling film (110B_2),
wherein the wiring upper air gap (110_UAG) is in the second lower wiring filling film (110B_2).

12. The semiconductor device of any one of claims 1 to 11, comprising a wiring sidewall air gap (110_SAG) on a sidewall (110_SW) of the lower wiring line (110),
wherein the sidewall (110_SW) of the lower wiring line (110) connects the first surface of the lower wiring line (110) and the second surface of the lower wiring line (110) to each other.

13. The semiconductor device of any one of claims 1 to 12, wherein, in a plan view, the lower wiring line (110) intersects the upper wiring line (210).

14. The semiconductor device of any one of claims 1 to 13, wherein, in a plan view, the lower wiring line (110) is parallel to the upper wiring line (210).
